# EUROPEAN PATENT APPLICATION

(11) **EP 4 318 568 A1**
(43) Date of publication of application: **07.02.2024**
(21) Application number: 22780264.2
(22) Date of filing: 18.03.2022
(51) Int. Cl.: H01L 23/12, H01L 23/29, H01L 23/31, C08L 67/02, C08J 5/04, C08G 63/19, H05K 1/03

(54) **POLYESTER RESIN**

(30) Priority: 29.03.2021 JP 2021055986
(71) Applicant: AJINOMOTO CO., INC., Chuo-ku Tokyo 104-8315 (JP)
(72) Inventor: OGURA, Ichiro, Kawasaki-shi, Kanagawa 210-0801 (JP); SATO, Naoya, Kawasaki-shi, Kanagawa 210-0801 (JP)
(74) Representative: Mewburn Ellis LLP
(86) International application number: PCT/JP2022/012818
(87) International publication number: WO 2022/210049

(57) **Abstract**

Provided is a polyester resin which achieves a cured product exhibiting excellent dielectric properties and favorable chemical resistance in combination with a cross-linkable resin. The polyester resin contains both the following skeleton (A) and skeleton (B):
<Skeleton (A)> a skeleton represented by the formula: (-) R¹-O-C(=O)-R³-, and
<Skeleton (B)> a skeleton represented by the formula: -R²-O-C(=O)-R³-
(in the formulas,
R¹ represents a monovalent or divalent aromatic group,
R² represents a divalent aliphatic group, and
R³ represents a divalent aromatic group).

## Description

### TECHNICAL FIELD

The present invention relates to a polyester resin. Furthermore, the present invention relates to a resin composition, a resin sheet, a prepreg, a cured product, a printed wiring board, a semiconductor chip package and a semiconductor device, which are obtained using the polyester resin.

### BACKGROUND ART

A resin composition containing a cross-linkable resin such as an epoxy resin and a cross-linking agent (curing agent) for the resin is widely used as a material for an electronic component such as a semiconductor or a printed wiring board, since it produces a cured product that is excellent in insulation, heat resistance, adhesion, and the like.

On the other hand, a high-speed communication such as a 5th generation mobile communication system (5G) has a problem of transmission loss in an operation under a high-frequency environment. To cope with such problems, an insulation material with remarkably excellent dielectric properties (low dielectric constant and low dielectric loss tangent) is required. Furthermore, in a printed wiring board, as the wiring becomes finer and the shape becomes thinner, a problem such as a delamination defect between a via or a wiring pattern and an insulation material tends to occur more easily. In order to prevent this, there is a strong demand for an improvement in durability of the insulation material against a liquid chemical such as a desmear liquid.

As a resin material having excellent dielectric properties, for example, Patent Literature 1 discloses, as a cross-linking agent for an epoxy resin, an active ester resin which is a reaction product of a divalent aromatic hydroxy compound and an aromatic diacid chloride. Furthermore, Patent Literature 2 discloses a copolymerized polyester resin obtained by reacting aromatic diols (such as a hydroxyalkylene-etherified product of bisphenols) and aliphatic diols with aromatic carboxylic acids.

### RELATED ART REFERENCE

### Patent Literature

Patent Literature 1: Japanese Patent Application Laid-Open No. 2009-235165 A
Patent Literature 2: Japanese Patent Application Laid-Open No. 2014-25022 A

### SUMMARY OF INVENTION

### PROBLEM TO BE SOLVED BY THE INVENTION

The active ester resin described in Patent Literature 1 has significantly excellent dielectric properties as compared with a conventional phenol-based cross-linking agent and the like. However, the transmission loss required for 5G applications is below a sufficiently satisfactory level. Furthermore, in order to further improve dielectric properties using this resin, there is a method of adjusting a blending ratio (mass ratio) relative to the cross-linkable resin. The dielectric properties can be highly improved by increasing the blending ratio of the active ester resin to such an extent that the amount of the active ester groups become excessive relative to that of the epoxy groups. At the same time, however, the strongly acidic and strongly basic chemicals used in the desmear process hydrolyze the excessive active ester groups and weaken the structure, resulting in a serious side effect of causing a crack defect or an interfacial delamination defect more easily. Thus, it has been difficult to adopt such a method.

Furthermore, the polyester resin described in Patent Literature 2 is a thermoplastic resin having Tg of 135°C or higher as described in Example and does not have physical properties that allow the polyester resin to be blended in the resin composition and used as a cross-linking agent for the cross-linkable resin. Furthermore, a diol component used for synthesizing the polyester resin has two aliphatic hydroxy groups.

An object of the present invention is to provide a polyester resin which achieves a cured product exhibiting excellent dielectric properties and favorable chemical resistance in combination with a cross-linkable resin.

### MEANS FOR SOLVING PROBLEM

As a result of intensive studies, the present inventors have found that the above-mentioned problem can be solved by a polyester resin having the following configuration, thereby completing the present invention.

That is, the present invention includes the following contents.
<1> A polyester resin containing both the following skeleton (A) and skeleton (B):
   <Skeleton (A)> a skeleton represented by the formula: (-)R¹-O-C(=O)-R³-, and
   <Skeleton (B)> a skeleton represented by the formula: -R²-O-C(=O)-R³-
   (in the formulas,
      R¹ represents a monovalent or divalent aromatic group,
      R² represents a divalent aliphatic group, and
      R³ represents a divalent aromatic group).
<2> The polyester resin according to <1>, wherein the polyester resin is blocked at its molecular chain terminal with the skeleton (A) (in the formula, R¹ represents a monovalent aromatic group).
<3> The polyester resin according to <1> or <2>, wherein a molar ratio of oxycarbonyl groups derived from the skeleton (A) to oxycarbonyl groups derived from the skeleton (B) ((A):(B)) is in a range of 30:70 to 95:5.
<4> The polyester resin according to any one of <1> to <3>, wherein:
   an equivalent weight of total oxycarbonyl groups is 170 g/eq. or more; and
   an equivalent weight of oxycarbonyl groups derived from the skeleton (A) is 220 g/eq. or more.
<5> The polyester resin according to any one of <1> to <4>, wherein a divalent aliphatic group represented by R² has 2 to 5 carbon atoms.
<6> The polyester resin according to any one of <1> to <5>, wherein
   the polyester resin is a condensation reaction product of:
   (x1) a hydroxy compound including at least a hydroxy compound having both an aromatic hydroxy group and an aliphatic hydroxy group;
   (x2) a divalent aromatic carboxylic acid compound or a divalent aromatic carboxylic acid halide compound; and
   (x3) a monovalent hydroxy compound having an aromatic hydroxy group.
<7> The polyester resin according to <6>, wherein the hydroxy compound (x1) is a reaction product of:
   a hydroxy compound having two or more aromatic hydroxy groups; and
   an aliphatic carbonate or an aliphatic oxide.
<8> The polyester resin according to <6> or <7>, wherein the hydroxy compound (x1) includes 10 mol% or more of a hydroxy compound having both an aromatic hydroxy group and an aliphatic hydroxy group.
<9> The polyester resin according to any one of <1> to <8>, containing a structural unit i represented by the following formula (i): 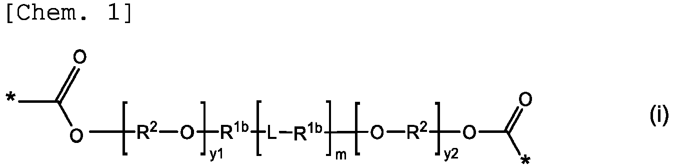 (in the formula:
   R^{1b}s each independently represent a divalent aromatic group;
   R²s each independently represent a divalent aliphatic group;
   Ls each independently represent a single bond or a divalent linking group;
   m is an integer of 0 to 5;
   y1 and y2 are each independently 0 or 1; and
   * indicates a bond, the bond being bonded to R³, where R³ indicates a divalent aromatic group).
<10> The polyester resin according to <9>, wherein, when an average number of the structural units i contained in the polyester resin per molecule is defined as N, N satisfies 0 < N ≤ 8.
<11> The polyester resin according to <9> or <10>, wherein, when an average number of the structural units i contained in the polyester resin per molecule is defined as N, an average number of a sum of a structural unit i-a represented by the following formula (i-a) and a structural unit i-b represented by the following formula (i-b) contained in the polyester resin per molecule is 0.1N or more: 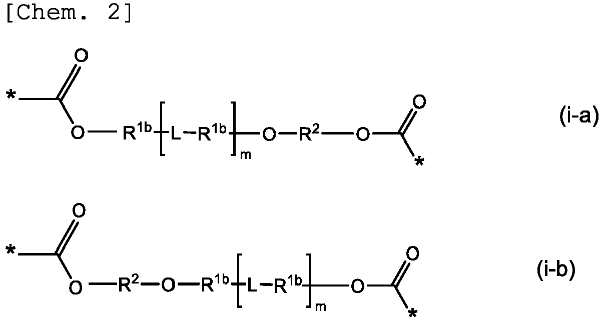 (in the formulas,
   R^{1b}, R², L, m, and * are the same as above) .
<12> The polyester resin according to any one of <1> to <11>, represented by the following formula (1): 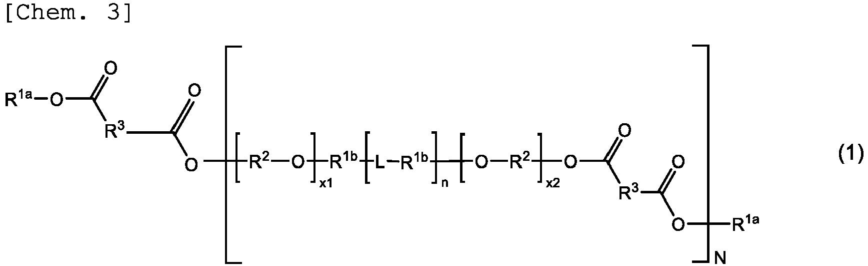 (in the formula:
   R^{1a}s each independently represent a monovalent aromatic group;
   R^{1b}s each independently represent a divalent aromatic group;
   R²s each independently represent a divalent aliphatic group;
   R³s each independently represent a divalent aromatic group;
   Ls each independently represents a single bond or a divalent linking group;
   x1 and x2 represent numbers that satisfy 0 ≤ x1 ≤ 1, 0 ≤ x2 ≤ 1, and 0 < x1 + x2 < 2;
   n represents a number in a range of 0 to 5; and
   N represents a repeating number satisfying 0 < N ≤ 8.) .
<13> The polyester resin according to <12>, wherein x1 and x2 satisfy 0.1 ≤ x1 + x2 ≤ 1.5.
<14> The polyester resin according to <12> or <13>, wherein x1 and x2 satisfy one of the following conditions (a) to (c) :
   (a) x1 = 0 and 0 < x2 ≤ 1,
   (b) x2 = 0 and 0 < x1 ≤ 1, and
   (c) when the number of molecules of the polyester resin is defined as Z, only one of x1 and x2 is 0 in at least one combination of x1 and x2 out of Z × N combinations of x1 and x2.
<15> The polyester resin according to any one of <12> to <14>, wherein R^{1a} is a phenyl group optionally having a substituent or a naphthyl group optionally having a substituent.
<16> The polyester resin according to any one of <9> to <15>, wherein a divalent aliphatic group represented by R² has 2 to 5 carbon atoms.
<17> The polyester resin according to any one of <9> to <16>, wherein R^{1b} is a phenylene group optionally having a substituent or a naphthylene group optionally having a substituent.
<18> The polyester resin according to any one of <9> to <17>, wherein L is a divalent aliphatic group optionally having a substituent or a divalent aromatic group optionally having a substituent.
<19> The polyester resin according to any one of <1> to <18>, having a number-average molecular weight of 5,000 or less.
<20> A resin cross-linking agent comprising the polyester resin according to any one of <1> to <19>.
<21> A resin composition comprising the polyester resin (X) according to any one of <1> to <19>, and a cross-linkable resin (Y).
<22> The resin composition according to <21>, wherein the cross-linkable resin (Y) is one or more types selected from the group consisting of a thermosetting resin and a radically polymerizable resin.
<23> The resin composition according to <21> or <22>, wherein a mass ration ((X)/(Y)) of the polyester resin (X) to the cross-linkable resin (Y) is 1.2 to 2.0.
<24> The resin composition according to any one of <21> to <23>, further comprising an inorganic filler.
<25> The resin composition according to any one of <21> to <24>, further comprising an organic solvent.
<26> The resin composition according to any one of <21> to <25>, for an insulation layer of a printed wiring board.
<27> The resin composition according to any one of <21> to <25>, for sealing semiconductor.
<28> A resin sheet comprising: a support; and a layer of the resin composition according to any one of <21> to <27>, disposed on the support.
<29> A prepreg formed by impregnating a sheet-like fiber substrate with the resin composition according to any one of <21> to <27>.
<30> A cured product of the resin composition according to any one of <21> to <27>.
<31> A printed wiring board comprising an insulation layer formed of a cured product of the resin composition according to any one of <21> to <26>.
<32> A semiconductor chip package comprising a sealing layer formed of a cured product of the resin composition according to any one of <21> to <25> and <27>.
<33> The semiconductor chip package according to <32>, wherein the semiconductor chip package is a fan-out type package.
<34> A semiconductor device comprising the printed wiring board according to <31> or the semiconductor chip package according to <32> or <33>.

### EFFECT OF THE INVENTION

According to the present invention, it is possible to provide the polyester resin which achieves a cured product exhibiting excellent dielectric properties and favorable chemical resistance in combination with the cross-linkable resin.

### BRIEF DESCRIPTION OF DRAWINGS

FIG. 1A is a GPC chart of a polyester resin (1) in Example 1.
FIG. 1B is an IR chart of the polyester resin (1) in Example 1.
FIG. 2A is a GPC chart of a polyester resin (2) in Example 2.
FIG. 2B is an IR chart of the polyester resin (2) in Example 2.
FIG. 3A is a GPC chart of a polyester resin (3) in Example 3.
FIG. 3B is an IR chart of the polyester resin (3) in Example 3.
FIG. 4A is a GPC chart of a polyester resin (4) in Example 4.
FIG. 4B is an IR chart of the polyester resin (4) in Example 4.
FIG. 5A is a GPC chart of a polyester resin (5) in Example 5.
FIG. 5B is an IR chart of the polyester resin (5) in Example 5.
FIG. 6A is a GPC chart of a polyester resin (6) in Example 6.
FIG. 6B is an IR chart of the polyester resin (6) in Example 6.
FIG. 7A is a GPC chart of a polyester resin (7) in Example 7.
FIG. 7B is an IR chart of the polyester resin (7) in Example 7.
FIG. 8A is a GPC chart of a polyester resin (8) in Example 8.
FIG. 8B is an IR chart of the polyester resin (8) in Example 8.
FIG. 9A is a GPC chart of a polyester resin (9) in Example 9.
FIG. 9B is an IR chart of the polyester resin (9) in Example 9.
FIG. 10A is a GPC chart of a polyester resin (10) in Comparative Example 1.
FIG. 10B is an IR chart of the polyester resin (10) in Comparative Example 1.

### EMBODIMENT FOR CARRYING OUT THE INVENTION

### <Description of Terms>

In the present specification, the term "optionally having a substituent" with respect to a compound or group means both a case where a hydrogen atom of the compound or group is not substituted with a substituent and a case where a part or all of the hydrogen atoms of the compound or group are substituted with a substituent.

In the present specification, unless otherwise specified, the term "substituent" means a halogen atom, an alkyl group, a cycloalkyl group, an alkoxy group, a cycloalkyloxy group, an aryl group, an aryloxy group, an arylalkyl group, an arylalkoxy group, a monovalent heterocyclic group, an alkylidene group, an amino group, a silyl group, an acyl group, an acyloxy group, a carboxy group, a sulfo group, a cyano group, a nitro group, a hydroxy group, a mercapto group, and an oxo group.

Examples of the halogen atom used as the substituent may include a fluorine atom, a chlorine atom, a bromine atom, and an iodine atom.

An alkyl group used as the substituent may be either linear or branched. The number of carbon atoms in the alkyl group is preferably 1 to 20, more preferably 1 to 14, further preferably 1 to 12, still further preferably 1 to 6, and particularly preferably 1 to 3. Examples of such alkyl groups may include a methyl group, an ethyl group, a propyl group, an isopropyl group, a butyl group, a sec-butyl group, an isobutyl group, a tert-butyl group, a pentyl group, a hexyl group, a heptyl group, an octyl group, a nonyl group, and a decyl group.

The number of carbon atoms in the cycloalkyl group used as the substituent is preferably 3 to 20, more preferably 3 to 12, and further preferably 3 to 6. Examples of the cycloalkyl group may include a cyclopropyl group, a cyclobutyl group, a cyclopentyl group, and a cyclohexyl group.

An alkoxy group used as the substituent may be either linear or branched. The number of carbon atoms in the alkoxy group is preferably 1 to 20, more preferably 1 to 12, and further preferably 1 to 6. Examples of the alkoxy group may include a methoxy group, an ethoxy group, a propyloxy group, an isopropyloxy group, a butoxy group, a sec-butoxy group, an isobutoxy group, a tert-butoxy group, a pentyloxy group, a hexyloxy group, a heptyloxy group, an octyloxy group, a nonyloxy group, and a decyloxy group.

The number of carbon atoms in the cycloalkyloxy group used as the substituent is preferably 3 to 20, more preferably 3 to 12, and further preferably 3 to 6. Examples of the cycloalkyloxy group may include a cyclopropyloxy group, a cyclobutyloxy group, a cyclopentyloxy group, and a cyclohexyloxy group.

An aryl group used as the substituent is a group obtained by removing one hydrogen atom on an aromatic ring from an aromatic hydrocarbon. The number of carbon atoms in the aryl group used as the substituent is preferably 6 to 24, more preferably 6 to 18, further preferably 6 to 14, and still further preferably 6 to 10. Examples of the aryl group may include a phenyl group, a naphthyl group, and an anthracenyl group.

The number of carbon atoms in the aryloxy group used as the substituent is preferably 6 to 24, more preferably 6 to 18, further preferably 6 to 14, and still further preferably 6 to 10. Examples of the aryloxy group used as the substituent may include a phenoxy group, a 1-naphthyloxy group, and a 2-naphthyloxy group.

The number of carbon atoms in the arylalkyl group used as the substituent is preferably 7 to 25, more preferably 7 to 19, further preferably 7 to 15, and still further preferably 7 to 11. Examples of the arylalkyl group may include a phenyl-C₁ to C₁₂ alkyl group, a naphthyl-C₁ to C₁₂ alkyl group, and an anthracenyl-C₁ to C₁₂ alkyl group.

The number of carbon atoms in the arylalkoxy group used as the substituent is preferably 7 to 25, more preferably 7 to 19, further preferably 7 to 15, and still further preferably 7 to 11. Examples of the arylalkoxy group may include a phenyl-C₁ to C₁₂ alkoxy group and a naphthyl-C₁ to C₁₂ alkoxy group.

A monovalent heterocyclic group used as the substituent refers to a group obtained by removing one hydrogen atom from a heterocyclic ring of a heterocyclic compound. The number of carbon atoms in the monovalent heterocyclic group is preferably 3 to 21, more preferably 3 to 15, and further preferably 3 to 9. The monovalent heterocyclic group also includes a monovalent aromatic heterocyclic group (heteroaryl group). Examples of the monovalent heterocyclic ring may include a thienyl group, a pyrrolyl group, a furanyl group, a furyl group, a pyridyl group, a pyridazinyl group, a pyrimidyl group, a pyrazinyl group, a triazinyl group, a pyrrolidyl group, a piperidyl group, a quinolyl group, and an isoquinolyl group.

An alkylidene group used as the substituent refers to a group in which two hydrogen atoms are removed from the same carbon atom of an alkane. The number of carbon atoms in the alkylidene group is preferably 1 to 20, more preferably 1 to 14, further preferably 1 to 12, still further preferably 1 to 6, and particularly preferably 1 to 3. Examples of the alkylidene group may include a methylidene group, an ethylidene group, a propylidene group, an isopropylidene group, a butylidene group, a sec-butylidene group, an isobutylidene group, a tert-butylidene group, a pentylidene group, a hexylidene group, a heptylidene group, an octylidene group, a nonylidene group, and a decylidene group.

An acyl group used as the substituent refers to a group represented by the formula: -C(=O)-R (in the formula, R is an alkyl group or an aryl group). The alkyl group represented by R may be either linear or branched. Examples of the aryl group represented by R may include a phenyl group, a naphthyl group, and an anthracenyl group. The number of carbon atoms in the acyl group is preferably 2 to 20, more preferably 2 to 13, and further preferably 2 to 7. Examples of the acyl group may include an acetyl group, a propionyl group, a butyryl group, an isobutyryl group, a pivaloyl group, and a benzoyl group.

An acyloxy group used as the substituent refers to a group represented by the formula:-O-C(=O)-R (in the formula, R is an alkyl group or an aryl group). The alkyl group represented by R may be either linear or branched. Examples of the aryl group represented by R may include a phenyl group, a naphthyl group, and an anthracenyl group. The number of carbon atoms in the acyloxy group is preferably 2 to 20, more preferably 2 to 13, and further preferably 2 to 7. Examples of the acyloxy group may include an acetoxy group, a propionyloxy group, a butyryloxy group, an isobutyryloxy group, a pivaloyloxy group, and a benzoyloxy group.

The above-mentioned substituent may further have a substituent (hereinafter, sometimes referred to as a "secondary substituent"). As the secondary substituent, the same substituents as those described above may be used, unless otherwise specified.

In the present specification, the term "aromatic group" refers to a group in which one or more hydrogen atoms are removed from the aromatic ring of an aromatic compound. Specifically, a monovalent aromatic group refers to a group obtained by removing one hydrogen atom from the aromatic ring of an aromatic compound, and a divalent aromatic group refers to a group obtained by removing two hydrogen atoms from the aromatic ring of an aromatic compound. In addition, the term "aromatic ring" means a ring according to the Huckel's rule in which the number of electrons contained in the π-electron system on the ring is 4n+2 (n is a natural number), and includes a monocyclic aromatic ring and a condensed aromatic ring in which two or more monocyclic aromatic rings are condensed. The aromatic ring may be a carbocyclic or heterocyclic ring. Examples of the monovalent aromatic group may include an aryl group optionally having a substituent and a heteroaryl group optionally having a substituent. Examples of the divalent aromatic group may include an arylene group optionally having a substituent and a heteroarylene group optionally having a substituent. In the present specification, unless otherwise specified, the number of carbon atoms in the aromatic group is preferably 3 or more, more preferably 4 or more, 5 or more, and further preferably 6 or more, and the upper limit thereof is preferably 24 or less, more preferably 18 or less, or 14 or less, and further preferably 10 or less. The number of carbon atoms does not include the number of carbon atoms of the substituent.

In the present specification, the term "aliphatic group" refers to a group in which one or more hydrogen atoms bonded to the aliphatic carbon of an aliphatic compound are removed. Specifically, a monovalent aliphatic group refers to a group obtained by removing one hydrogen atom bonded to the aliphatic carbon of an aliphatic compound, and a divalent aliphatic group refers to a group obtained by removing two hydrogen atoms bonded to the aliphatic carbon of an aliphatic compound. Examples of the monovalent aliphatic group may include an alkyl group optionally having a substituent, a cycloalkyl group optionally having a substituent, an alkenyl group optionally having a substituent, and a cycloalkenyl group optionally having a substituent. Examples of the divalent aliphatic group may include an alkylene group optionally having a substituent, a cycloalkylene group optionally having a substituent, an alkenylene group optionally having a substituent, and a cycloalkenylene group optionally having a substituent. In the present specification, the number of carbon atoms in the aliphatic group is preferably 1 to 20, more preferably 1 to 14, 1 to 12 or 1 to 6, and further preferably 1 to 3, unless otherwise specified. The number of carbon atoms does not include the number of carbon atoms of the substituent.

Hereinafter, the present invention will be described in detail with reference to preferred embodiments thereof. However, the present invention is not limited to the embodiments and examples described below. The present invention may be optionally modified for implementation without departing from the scope of claims of the present invention and the scope of equivalents thereof.

### [Polyester resin]

The polyester resin of the present invention contains both the following skeleton (A) and skeleton (B):
<Skeleton (A)> a skeleton represented by the formula: (-)R¹-O-C(=O)-R³-, and
<Skeleton (B)> a skeleton represented by the formula: -R²-O-C(=O)-R³-
(in the formulas,
   R¹ represents a monovalent or divalent aromatic group,
   R² represents a divalent aliphatic group, and
   R³ represents a divalent aromatic group).

When the polyester resin of the present invention contains both the skeleton (A) and the skeleton (B), it is possible to achieve a cured product exhibiting excellent dielectric properties and favorable chemical resistance in combination with the cross-linkable resin. Preferable ranges of the molecular weight of the polyester resin and the content ratio between the skeleton (A) and the skeleton (B) will be described later.

### -Skeleton (A)-

The skeleton (A) is a skeleton represented by the formula: (-)R¹-O-C(=O)-R³- (in the formula, R¹ represents a monovalent or divalent aromatic group and R³ represents a divalent aromatic group).

When the polyester resin of the present invention contains the skeleton (A), the polyester resin can be used to be blended to a resin composition as a crosslinking agent of a cross-linkable resin.

When R¹ represents a monovalent aromatic group, the skeleton (A) is represented by the formula: R¹-O-C(=O)-R³-. When R¹ represents a divalent aromatic group, the skeleton (A) is represented by the formula -R¹-O-C(=O)-R³-. It is preferable that the polyester resin of the present invention contains, as the skeleton (A), both the skeleton represented by the formula: R¹-O-C(=O)-R³- and the skeleton represented by the formula: -R¹-O-C(=O)-R³-.

In a preferred embodiment, the polyester resin of the present invention is blocked at its molecular chain terminal (preferably at both terminals) with the skeleton (A) (in the formula, R¹ represents a monovalent aromatic group). The polyester resin of the present invention preferably contains the skeleton (A) (in the formula, R¹ represents a divalent aromatic group) together with the skeleton (B), to be described later, within the molecular chain thereof.

The monovalent aromatic group represented by R¹ is preferably an aryl group optionally having a substituent, from the viewpoint of further achieving the advantageous effects of the present invention. The number of carbon atoms in the aryl group in R¹ is preferably 6 to 18, more preferably 6 to 14, and further preferably 6 to 10. The number of carbon atoms does not include the number of carbon atoms of the substituent. In a preferred embodiment, the monovalent aromatic group represented by R¹ is a phenyl group optionally having a substituent or a naphthyl group optionally having a substituent, and is more preferably a naphthyl group optionally having a substituent.

The substituents which the aryl group in R¹ may have are as described above. Among these, the substituent is preferably one or more types selected from a halogen atom, an alkyl group, and an aryl group, and more preferably one or more types selected from a fluorine atom, an alkyl group of 1 to 6 carbon atoms, and an aryl group of 6 to 10 carbon atoms.

The divalent aromatic group represented by R¹ is preferably an arylene group optionally having a substituent, from the viewpoint of further achieving the advantageous effects of the present invention. The number of carbon atoms in the arylene group in R¹ is preferably 6 to 18, more preferably 6 to 14, and further preferably 6 to 10. The number of carbon atoms does not include the number of carbon atoms of the substituent. In a preferred embodiment, the divalent aromatic group represented by R¹ is a phenylene group optionally having a substituent or a naphthylene group optionally having a substituent, and more preferably a phenylene group optionally having a substituent.

The substituents which the arylene group in R¹ may have are as described above. Among these, the substituent is preferably one or more types selected from a halogen atom, an alkyl group, an aryl group, an arylalkyl group, and a hydroxy group, and more preferably one or more types selected from a fluorine atom, an alkyl group of 1 to 6 carbon atoms, an aryl group of 6 to 10 carbon atoms, an arylalkyl group (an aryl group of 6 to 10 carbon atoms and an alkyl group of 1 to 6 carbon atoms), and a hydroxy group.

The divalent aromatic group represented by R³ is preferably an arylene group optionally having a substituent, from the viewpoint of further achieving the advantageous effects of the present invention. The number of carbon atoms in the arylene group in R¹ is preferably 6 to 18, more preferably 6 to 14, and further preferably 6 to 10. The number of carbon atoms does not include the number of carbon atoms of the substituent. In a preferred embodiment, the divalent aromatic group represented by R³ is a phenylene group optionally having a substituent or a naphthylene group optionally having a substituent, and more preferably a phenylene group optionally having a substituent.

The substituents which the arylene group in R³ may have are as described above. Among these, the substituent is preferably one or more types selected from a halogen atom, an alkyl group, and an aryl group, and more preferably one or more types selected from a fluorine atom, an alkyl group of 1 to 6 carbon atoms, and an aryl group of 6 to 10 carbon atoms.

The polyester resin of the present invention preferably contains two or more skeletons (A) within the molecule. In the polyester resin of the present invention, the average number of the skeletons (A) contained within the molecule is preferably 2.2 or more, more preferably 2.4 or more, and further preferably 2.5 or more. The upper limit of the average number of the skeletons (A) is not particularly limited, and it is preferable to satisfy a preferable range of the molecular weight of the polyester resin to be described later, a preferable range of the molar ratio thereof to the skeleton (B), and a preferable range of the equivalent weight of oxycarbonyl groups derived from the skeleton (A). For example, the upper limit thereof may be 10 or less, and 8 or less.

### -Skeleton (B)-

The skeleton (B) is a skeleton represented by the formula: -R²-O-C(=O)-R³- (in the formula, R² represents a divalent aliphatic group and R³ represents a divalent aromatic group).

When containing the skeleton (B), the polyester resin of the present invention can produce a cured product having favorable chemical resistance even if the blending ratio (mass ratio) with respect to the cross-linkable resin is increased in order to achieve transmission loss required for 5G applications, and thus, it is possible to prevent occurrence of a crack defect or an interfacial delamination defect.

As described above, the polyester resin of the present invention preferably contains the skeleton (B) within its molecular chain.

The divalent aliphatic group represented by R² is preferably an alkylene group optionally having a substituent, from the viewpoint of achieving the advantageous effects of the present invention. The alkylene group in R² may be linear or branched, and the number of carbon atoms therein is preferably 1 to 6, more preferably 2 to 5, and further preferably 2 or 3. The number of carbon atoms does not include the number of carbon atoms of the substituent. In a preferred embodiment, the number of carbon atoms in the divalent aliphatic group represented by R² is 2 to 5, and more preferably 2 or 3.

The substituents which the alkylene group in R² may have are as described above. Among these, the substituent is preferably one or more types selected from a halogen atom, an alkyl group, and an aryl group, and more preferably one or more types selected from a fluorine atom, an alkyl group of 1 to 6 carbon atoms, and an aryl group of 6 to 10 carbon atoms.

The divalent aromatic group represented by R³ is as described for the skeleton (A), and preferred embodiments thereof are also the same.

From the viewpoint of achieving a cured product exhibiting excellent dielectric properties and favorable chemical resistance in combination with the cross-linkable resin, the content ratio of the skeleton (B) in the polyester resin of the present invention is preferably within a predetermined range. Specifically, it is preferable to adjust the content ratio of the skeleton (B) so that the ratio [(A)/((A)+(B))] of the number of oxycarbonyl groups derived from the skeleton (A) to the total number of oxycarbonyl groups derived from the skeleton (A) and oxycarbonyl groups derived from the skeleton (B) is preferably 0.3 or more, more preferably 0.4 or more, further preferably 0.45 or more, or 0.5 or more, and the upper limit of the ratio [(A)/((A)+(B))] is preferably 0.95 or less, more preferably 0.9 or less, and further preferably 0.85 or less or 0.8 or less.

Accordingly, in a preferred embodiment, the molar ratio of oxycarbonyl groups derived from the skeleton (A) to oxycarbonyl groups derived from the skeleton (B) ((A):(B)) is from 30:70 to 95:5. The ratio ((A):(B)) is more preferably from 40:60 to 90:10, and further preferably from 45:55 to 85:15 or from 50:50 to 80:20.

In the polyester resin of the present invention, the equivalent weight of oxycarbonyl groups is preferably within a predetermined range from the viewpoint of achieving a cured product exhibiting excellent dielectric properties and favorable chemical resistance in combination with the cross-linkable resin.

Specifically, the equivalent weight of the total oxycarbonyl groups including oxycarbonyl groups derived from the skeleton (A) and oxycarbonyl groups derived from the skeleton (B) is preferably 170 g/eq. or more, more preferably 180 g/eq. or more, and further preferably 190 g/eq. or more or 200 g/eq. or more. The upper limit of the equivalent weight of the total oxycarbonyl groups can be, for example, 500 g/eq. or less, 450 g/eq. or less, or 400 g/eq. or less.

The equivalent weight of oxycarbonyl groups derived from the skeleton (A) is higher than the equivalent weight of the total oxycarbonyl groups, preferably 220 g/eq. or higher, more preferably 240 g/eq. or higher, further preferably 260 g/eq. or higher, 280 g/eq. or higher, or 300 g/eq. or higher. The upper limit of the equivalent weight of oxycarbonyl groups derived from the skeleton (A) can be, for example, less than 1000 g/eq., 800 g/eq. or less, 600 g/eq. or less, 500 g/eq. or less, and the like.

In a preferred embodiment, the equivalent weight of the total oxycarbonyl groups is 170 g/eq. or more and the equivalent weight of oxycarbonyl groups derived from the skeleton (A) is 220 g/eq. or more.

In an embodiment, the polyester resin of the present invention includes a structural unit i represented by the following formula (i). 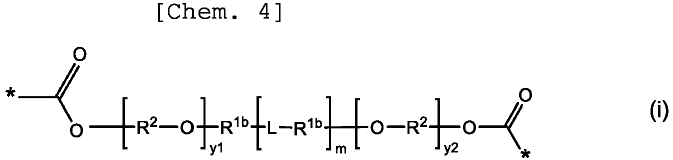 (in the formula:
R^{1b}s each independently represent a divalent aromatic group;
R²s each independently represent a divalent aliphatic group;
Ls each independently represent a single bond or a divalent linking group;
m is an integer of 0 to 5;
y1 and y2 are each independently 0 or 1; and
* indicates a bond, the bond being bonded to R³, where R³ indicates a divalent aromatic group)

In the structural unit i, a moiety represented by *-C(=O)-O-R^{1b}- when y1 is 0 (* is bonded to R³) and a moiety represented by -R^{1b}-O-C(=O)-* when y2 is 0 (* is bonded to R³) correspond to the above-mentioned skeleton (A) (R¹ is a divalent aromatic group). Furthermore, a moiety represented by *-C(=O)-O-R²- when y1 is 1 (* is bonded to R³) and a moiety represented by -R²-O-C(=O)-* when y2 is 1 (* is bonded to R³) correspond to the above-mentioned skeleton (B).

As described above, from the viewpoint of achieving a cured product exhibiting excellent dielectric properties and favorable chemical resistance in combination with the cross-linkable resin, the polyester resin of the present invention includes the skeleton (B) in addition to the above-mentioned skeleton (A). Thus, in at least one structural unit i included in the polyester resin of the present invention, one or both of y1 and y2 (preferably one of y1 and y2) are 1. In the structural unit i, values of y1 and y2 can be adjusted, in the preparation of the raw material hydroxy compound (component (x1) described below) used for synthesizing the polyester resin, by reacting the hydroxy compound having two or more aromatic hydroxy groups with an aliphatic carbonate or the like and thereby converting the aromatic hydroxy group to the aliphatic hydroxy group. That is, y1 and y2 are 1 when the conversion to the aliphatic hydroxy group occurs, while y1 and y2 are 0 when the conversion to the aliphatic hydroxy group does not occur (when the aromatic hydroxy group remains unconverted). A preferred embodiment of the structural unit i will be described below in relation to the average number N of the structural unit i contained in the polyester resin per molecule.

R^{1b} corresponds to a divalent aromatic group represented by R¹ in the skeleton (A), and preferred embodiments thereof are as described for R¹. In a preferred embodiment, R^{1b} is a phenylene group optionally having a substituent or a naphthylene group optionally having a substituent, and more preferably a phenylene group optionally having a substituent. Preferred embodiments of the substituent are also as described for R¹.

R² corresponds to R² in skeleton (B), and preferred embodiments thereof are as described for R² in the skeleton (B). In a preferred embodiment, the number of carbon atoms in the divalent aliphatic group represented by R² is 2 to 5, and more preferably 2 or 3.

The symbol "*" (asterisk) represents a bond, and R³ to which the bond is bonded corresponds to R³ in the skeleton (A) and the skeleton (B), and preferred examples thereof are as described for R³ in the skeleton (A) and the skeleton (B). In a preferred embodiment, the divalent aromatic group represented by R³ is a phenylene group optionally having a substituent or a naphthylene group optionally having a substituent, and more preferably a phenylene group optionally having a substituent. Preferred examples of the substituent are also as described for R³ in the skeleton (A) and the skeleton (B).

L represents a single bond or a divalent linking group. Examples of the divalent linking group represented by L may include divalent organic groups formed of one or more skeletal atoms (e.g., 1 to 3000, 1 to 1000, 1 to 100, and 1 to 50 skeletal atoms) selected from a carbon atom, an oxygen atom, a nitrogen atom, and a sulfur atom. Among these, a divalent aliphatic group optionally having a substituent or a divalent aromatic group optionally having a substituent is preferable. Therefore, in a preferred embodiment, L is a divalent aliphatic group optionally having a substituent or a divalent aromatic group optionally having a substituent.

Examples of the divalent aliphatic group in L may include an alkylene group, a cycloalkylene group, an alkenylene group, a cycloalkenylene group, and an alkapolyenylene group (the number of double bonds is preferably 2 to 10, more preferably 2 to 6, further preferably 2 to 4, and still further preferably 2). Among these, an alkylene group, a cycloalkylene group, an alkenylene group, and a cycloalkenylene group are preferable, an alkylene group and a cycloalkylene group are more preferable, and a cycloalkylene group is further preferable.

The alkylene group in L may be linear or branched, and the number of carbon atoms therein is preferably 1 to 12, more preferably 1 to 6, and further preferably 1 to 4. The number of carbon atoms does not include the number of carbon atoms of the substituent. Examples of the alkylene group may include a methylene group, an ethylene group, a propylene group, a butylene group, a pentylene group, and a hexylene group.

The number of carbon atoms in the cycloalkylene group in L is preferably 3 to 15, more preferably 3 to 12, and further preferably 3 to 10. The number of carbon atoms does not include the number of carbon atoms of the substituent. Examples of the cycloalkylene group may include a cyclopropylene group, a cyclobutylene group, a cyclopentylene group, a cyclohexylene group, a decahydronaphthalene group, a norbornanylene group, a dicyclopentanylene group, and an adamantanylene group.

The alkenylene group in L may be linear or branched, and the number of carbon atoms therein is preferably 2 to 12, more preferably 2 to 6, and further preferably 2 to 4. The number of carbon atoms does not include the number of carbon atoms of the substituent. Examples of the alkenylene group may include an ethenylene group, a propenylene group, a butenylene group, a pentenylene group, and a hexenylene group.

The number of carbon atoms in the cycloalkenylene group in L is preferably 3 to 15, more preferably 3 to 12, and further preferably 3 to 10. The number of carbon atoms does not include the number of carbon atoms of the substituent. Examples of the cycloalkenylene group may include a cyclopropenylene group, a cyclobutenylene group, a cyclopentenylene group, a cyclohexenylene group, and a norbornenylene group.

Examples of the divalent aromatic group in L may include an arylene group and a heteroarylene group, with an arylene group being preferable.

The number of carbon atoms in the arylene group in L is preferably 6 to 24, more preferably 6 to 18, and further preferably 6 to 14. The number of carbon atoms does not include the number of carbon atoms of the substituent. Examples of the arylene group may include a phenylene group, a naphthylene group, an anthracenylene group, a fluorenediyl group (for example, a 9H-fluorene-9,9-diyl group), a phenanthrenediyl group, an indanediyl group, and a pyrenediyl group.

The number of carbon atoms in the heteroarylene group in L is preferably 3 to 21, more preferably 3 to 15, and further preferably 3 to 9. The number of carbon atoms does not include the number of carbon atoms of the substituent. Examples of the heteroarylene group may include a pyrroldiyl group, a furandiyl group, a thiophenediyl group, a pyridinediyl group, a pyridazinediyl group, a pyrimidinediyl group, a pyrazinediyl group, a triazinediyl group, a piperidinediyl group, a triazolediyl group, a purinediyl group, a carbazolediyl group, a quinolinediyl group, and an isoquinolinediyl group.

From the viewpoint of achieving a cured product exhibiting excellent dielectric properties and favorable chemical resistance in combination with the cross-linkable resin, L is preferably an alkylene group of 1 to 12 carbon atoms optionally having a substituent, a cycloalkylene group of 3 to 15 carbon atoms optionally having a substituent, or an arylene group of 6 to 24 carbon atoms optionally having a substituent.

The substituent which the divalent group represented by L may have are as described above. Among these, the substituent is preferably one or more types selected from a halogen atom, an alkyl group, and an aryl group, and more preferably one or more types selected from a fluorine atom, an alkyl group of 1 to 6 carbon atoms, and an aryl group of 6 to 10 carbon atoms.

Note that m is an integer of 0 to 5, preferably 0 to 3, and more preferably 0 to 2. When m is 0, the divalent aromatic group represented by R^{1b} is preferably a naphthylene group optionally having a substituent.

When the average number of the structural units i contained in the polyester resin of the present invention per molecule is defined as N, N preferably satisfies 0 < N ≤ 8 from the viewpoint of using the polyester resin blended to the resin composition as a crosslinking agent of the cross-linkable resin. The upper limit of N is more preferably 7 or less, 6 or less, 5 or less, 4.5 or less, 4 or less, 3.5 or less, 3.4 or less, 3.2 or less, or 3 or less.

By including the above-mentioned skeleton (B), the cured product with favorable chemical resistance can be achieved, and as a result, the occurrence of a crack defect or an interfacial delamination defect can be suppressed, even if the blending ratio (mass ratio) of the polyester resin relative to the cross-linkable resin is increased to achieve the transmission loss required for 5G applications. From the viewpoint of further obtaining the above advantageous effects achieved by including the skeleton (B), when the average number of the structural units i contained in the polyester resin of the present invention per molecule is defined as N, the average number of the structural units i in which only one of y1 and y2 is 1, that is, the average number of the sum of structural units i-a represented by the following formula (i-a) and structural units i-b represented by the following formula (i-b) is preferably 0.1N or more. The average number is more preferably 0.2N or more, further preferably 0.3N or more, 0.4N or more, or 0.5N or more. 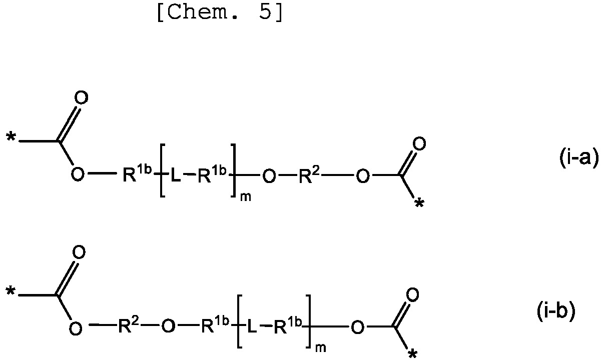 (in the formulas,
R^{1b}, R², L, m, and * are the same as above)

In an embodiment, the polyester resin of the present invention is represented by the following formula (1) . 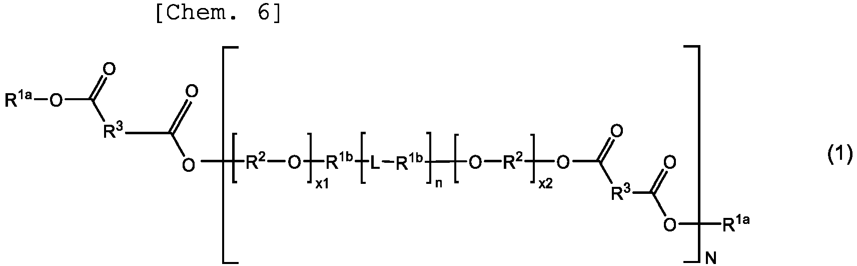 (in the formula:
R^{1a}s each independently represent a monovalent aromatic group;
R^{1b}s each independently represent a divalent aromatic group;
R²s each independently represent a divalent aliphatic group;
R³s each independently represent a divalent aromatic group;
Ls each independently represents a single bond or a divalent linking group;
x1 and x2 represent numbers that satisfy 0 ≤ x1 ≤ 1, 0 ≤ x2 ≤ 1, and 0 < x1 + x2 < 2;
n represents a number in a range of 0 to 5; and
N represents a repeating number that satisfies 0 < N ≤ 8.)

In the formula (1), a skeleton represented by R^{1a}-O-C(=O)-R³- at the molecular chain terminal corresponds to the above-mentioned skeleton (A) (R¹ is a monovalent aromatic group), and N structural units i described above are included within the molecular chain. Within the molecular chain, a skeleton represented by -R^{1b}-O-C(=O)-R³-corresponds to the above-mentioned skeleton (A) (R¹ is a divalent aromatic group), and a skeleton represented by - R²-O-C(=O)-R³- corresponds to the above-mentioned skeleton (B) .

R^{1a} corresponds to the monovalent aromatic group represented by R¹ in the skeleton (A), and preferable examples thereof are as described for R¹. In a preferred embodiment, R^{1a} is a phenyl group optionally having a substituent or a naphthyl group optionally having a substituent, and is more preferably a naphthyl group optionally having a substituent. Preferable examples of the substituent are also as described for R¹.

R^{1b} corresponds to the divalent aromatic group represented by R¹ in the skeleton (A), and preferable examples thereof are as described for R¹. In a preferred embodiment, R^{1b} is a phenylene group optionally having a substituent or a naphthylene group optionally having a substituent, and is more preferably a phenylene group optionally having a substituent. Preferable examples of the substituent are also as described for R¹.

R² corresponds to R² in the skeleton (B), and preferable examples thereof are as described for R² in the skeleton (B). In a preferred embodiment, the number of carbon atoms in the divalent aliphatic group represented by R² is 2 to 5, and more preferably 2 or 3.

R³ corresponds to R³ in the skeleton (A) and the skeleton (B), and preferable examples thereof are as described for R³ in the skeleton (A) and the skeleton (B). In a preferred embodiment, the divalent aromatic group represented by R³ is a phenylene group optionally having a substituent or a naphthylene group optionally having a substituent, and more preferably a phenylene group optionally having a substituent. Preferable examples of the substituent are also as described for R³ in the skeleton (A) and the skeleton (B).

L represents a single bond or a divalent linking group, and L and preferable examples thereof are as described for the structural unit i. In a preferred embodiment, L is a divalent aliphatic group optionally having a substituent or a divalent aromatic group optionally having a substituent. From the viewpoint of achieving a cured product exhibiting excellent dielectric properties and favorable chemical resistance in combination with the cross-linkable resin, L is preferably an alkylene group of 1 to 12 carbon atoms optionally having a substituent, a cycloalkylene group of 3 to 15 carbon atoms optionally having a substituent, or an arylene group of 6 to 24 carbon atoms optionally having a substituent. Preferable examples of the substituent are also as described for L in the structural unit i.

In the formula (1), x1 and x2 represent numbers that satisfy 0 ≤ x1 ≤ 1, 0 ≤ x2 ≤ 1, and 0 < x1 + x2 < 2. In this formula, x1 and x2 correspond to the average values of y1 and y2 in the above-mentioned structural unit i, respectively. As with y1 and y2, values of x1 and x2 can be adjusted, in the preparation of the raw material hydroxy compound (component (x1) described below) used for synthesizing the polyester resin, by converting the aromatic hydroxy group in the hydroxy compound having two or more aromatic hydroxy groups to the aliphatic hydroxy group, or by changing the extent of this conversion. The procedure for synthesizing the polyester resin will be described below.

From the viewpoint of achieving a cured product exhibiting excellent dielectric properties and favorable chemical resistance in combination with the cross-linkable resin, the sum of x1 and x2 (x1 + x2) is preferably 0.1 or more, more preferably 0.3 or more, further preferably 0.5 or more, 0.6 or more, or 0.8 or more. The upper limit of the sum (x1 + x2) is preferably 1.5 or less, more preferably 1.4 or less, and further preferably 1.2 or less or 1 or less. Thus, in a preferred embodiment, x1 and x2 in the formula (1) satisfy 0.1 ≤ x1 + x2 ≤ 1.5, and more preferably 0.5 ≤ x1 + x2 ≤ 1.2.

By including the above-mentioned skeleton (B), the cured product with favorable chemical resistance can be achieved, and as a result, the occurrence of a crack defect or an interfacial delamination defect can be suppressed, even if the blending ratio (mass ratio) of the polyester resin relative to the cross-linkable resin is increased to achieve the transmission loss required for 5G applications. From the viewpoint of further obtaining the above advantageous effects achieved by including the skeleton (B), it is particularly preferable that x1 and x2 satisfy one of the following conditions (a) to (c):
(a) x1 = 0 and 0 < x2 ≤ 1,
(b) x2 = 0 and 0 < x1 ≤ 1, and
(c) when the number of molecules of the polyester resin is defined as Z, only one of x1 and x2 is 0 in at least one combination of x1 and x2 out of Z × N combinations of x1 and x2.

All of the conditions (a) to (c) indicate that the raw material hydroxy compound used for synthesizing the polyester resin includes at least a hydroxy compound having both an aromatic hydroxy group and an aliphatic hydroxy group. In all of the conditions (a) to (c), values of x1 and x2 may be determined within the preferable range of the sum (x1 + x2) described above. In particular, regarding the condition (c), it is preferable that only one of x1 and x2 is 0 in preferably 0.1(Z × N) or more, more preferably 0.2(Z × N) or more, further preferably 0.3(Z × N) or more, 0.4(Z × N) or more, or 0.5(Z × N) or more combinations of x1 and x2 out of Z × N combinations of x1 and x2.

In the formula (1), n represents a number in a range of 0 to 5, preferably 0 to 3, and more preferably 0 to 2. Note that, when n is 0, the divalent aromatic group represented by R^{1b} is preferably a naphthylene group optionally having a substituent.

In a preferred embodiment, in the formula (1),
i) R^{1a} is a phenyl group optionally having a substituent or a naphthyl group optionally having a substituent,
ii) R² is a divalent aliphatic group of 2 to 5 carbon atoms,
iii) R³ is a phenylene group optionally having a substituent,
iv) (a) n is 0 and R^{1b} is a naphthylene group optionally having a substituent, or (b) n is 1 to 5, R^{1b} is a phenylene group optionally having a substituent, and L is an alkylene group of 1 to 12 carbon atoms optionally having a substituent, a cycloalkylene group of 3 to 15 carbon atoms optionally having a substituent or an arylene group of 6 to 24 carbon atoms optionally having a substituent.

In a further preferred embodiment, in the formula (1),
i) R^{1a} is a phenyl group optionally having one or more substituents selected from a halogen atom, an alkyl group, and an aryl group, or a naphthyl group optionally having one or more substituents selected from a halogen atom, an alkyl group, and an aryl group;
ii) R² is an alkylene group of 2 to 5 carbon atoms optionally having one or more substituents selected from a halogen atom, an alkyl group, and an aryl group,
iii) R³ is a phenylene group optionally having one or more substituents selected from a halogen atom, an alkyl group, and an aryl group,
iv) (a) n is 0 and R^{1b} is a naphthylene group optionally having one or more substituents selected from a halogen atom, an alkyl group, an aryl group, an arylalkyl group, and a hydroxy group, or (b) n is 1 to 5, R^{1b} is a phenylene group optionally having a substituent selected from a halogen atom, an alkyl group, an aryl group, an arylalkyl group, and a hydroxy group, and L is an alkylene group of 1 to 12 carbon atoms optionally having one or more substituents selected from a halogen atom, an alkyl group, and an aryl group; a cycloalkylene group of 3 to 15 carbon atoms optionally having one or more substituents selected from a halogen atom, an alkyl group, and an aryl group; and an arylene group of 6 to 24 carbon atoms optionally having one or more substituents selected from a halogen atom, an alkyl group, and an aryl group.

In the formula (1), N represents the repeating number, and represents a number satisfying 0 < N ≤ 8. The N corresponds to the average number of structural units i contained in the polyester resin of the present invention per molecule, and a preferable range thereof is as described above.

The number-average molecular weight (Mn) of the polyester resin of the present invention is preferably 5000 or less, more preferably 4000 or less, further preferably 3500 or less, or 3000 or less, from the viewpoint of blending the polyester resin to the resin composition as a crosslinking agent of the cross-linkable resin. The lower limit of Mn is not particularly limited as long as the polyester resin contains both the skeleton (A) and the skeleton (B), and may be, for example, 500 or more, and 600 or more. Mn of the polyester resin of the present invention may be measured as a polystyrene-equivalent value by a gel permeation chromatography (GPC) method. The above-described preferable ranges of Mn are based on values measured according to the methods in a below-described section (GPC measuring conditions).

An example of the procedure for synthesizing the polyester resin of the present invention will be described below.

In an embodiment, the polyester resin of the present invention is obtained by performing a condensation reaction of:
(x1) a hydroxy compound including at least a hydroxy compound having both an aromatic hydroxy group and an aliphatic hydroxy group;
(x2) a divalent aromatic carboxylic acid compound or a divalent aromatic carboxylic acid halide compound; and
(x3) a monovalent hydroxy compound having an aromatic hydroxy group.

-Hydroxy compound (x1)-

The component (x1) is a hydroxy compound including at least a hydroxy compound having both an aromatic hydroxy group and an aliphatic hydroxy group and is represented by the following formula (2). Using the hydroxy compound (x1) makes it possible to synthesize a polyester resin including both the skeleton (A) and the skeleton (B). 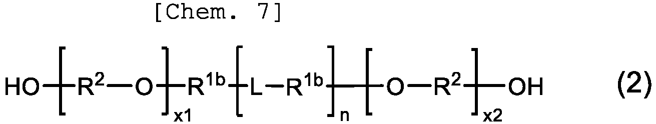 (in the formula, R^{1b}, R², L, x1, x2, and n are as described above)

The hydroxy compound (x1) can be prepared by reacting:
(x1-1) a hydroxy compound having two or more aromatic hydroxy groups (represented by the following formula (3)); and
(x1-2) an aliphatic carbonate or an aliphatic oxide (including R² as an aliphatic group). 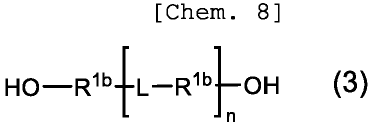
(in the formula, R^{1b}, L, and n are as described above)

As the component (x1-1), any aromatic polyol may be used as long as the desired structure of the polyester resin is achieved. Preferable examples and ranges of R^{1b}, L, and n are as described above. In the above-mentioned formula (3), two aromatic hydroxy groups (R^{1b}-OH) are shown. However, as described above, the divalent aromatic group represented by R^{1b} may have a hydroxy group as a substituent. Examples of such an aromatic polyol as a component in which n is 1 or more may include a polyaddition reaction product of an unsaturated aliphatic cyclic compound having two double bonds within one molecule and a phenol, and various bisphenol compounds. Examples of the polyaddition reaction product of the unsaturated aliphatic cyclic compound and the phenol include a polyaddition reaction product of an unsaturated aliphatic cyclic compound such as dicyclopentadiene, tetrahydroindene, norbornadiene, limonene, or vinylcyclohexene, and a phenol optionally having a substituent (e.g., phenol, cresol, xylenol, ethylphenol, propylphenol, vinylphenol, allylphenol, phenylphenol, benzylphenol, halophenol, etc.). Specific examples thereof may include a dicyclopentadiene-phenol polyaddition product. Examples of the bisphenol compound may include a bisphenol A, a bisphenol F, a bisphenol AF, a bisphenol AP, a bisphenol B, a bisphenol BP, a bisphenol C, and a bisphenol M. Furthermore, examples of the aromatic polyol as a component in which n is 0 may include a diol in which two hydroxy groups are bonded to a carbon atom on the aromatic ring (benzenediol, naphthalenediol, etc.).

Furthermore, as the component (x1-2), any aliphatic carbonate or aliphatic oxide may be used depending on R² in the desired skeleton (B). For example, if R² in the desired skeleton (B) is an alkylene group of 2 carbon atoms, ethylene carbonate or ethylene oxide may be used, and if R² in the desired skeleton (B) is an alkylene group of 3 carbon atoms, propylene carbonate or propylene oxide may be used.

In the reaction of the component (x1-1) and the component (x1-2), the aromatic hydroxy group (-R^{1b}-OH) of the component (x1-1) is converted to the aliphatic hydroxy group (-R^{1b}-O-R²-OH). In such a reaction, the conversion ratio to the aliphatic hydroxy group can be adjusted by changing a condition such as the amount ratio of the component (x1-1) and the component (x1-2). This can also adjust the composition of the resulting hydroxy compound (x1) (values of x1 and x2 in the formula (2)), and, correspondingly, the structure of the polyester resin (values of y1 and y2 in the structural unit i and values of x1 and x2 in the formula (1)).

From the viewpoint of further achieving the advantageous effects achieved by including the above-mentioned skeleton (B), it is preferable that the hydroxy compound (x1) includes the hydroxy compound having both the aromatic hydroxy group and the aliphatic hydroxy group in an amount of preferably 10 mol% or more, more preferably 20 mol% or more, further preferably 30 mol% or more, 40 mol% or more, or 50 mol % or more. Thus, in a preferred embodiment, the hydroxy compound (x1) includes 10 mol% or more of the hydroxy compound having both the aromatic hydroxy group and the aliphatic hydroxy group.

### -Divalent aromatic carboxylic acid (halide) compound (x2)-

The component (x2) is a divalent aromatic carboxylic acid compound or a divalent aromatic carboxylic acid halide compound and is represented by the following formula (4). 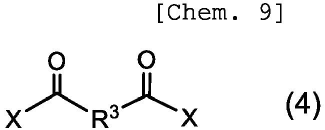 (in the formula, R³ is as described above, and X represents a hydroxy group or a halogen atom)

As the component (x2), any divalent aromatic carboxylic acid (halide) compound may be used depending on R³ in the desired skeleton (A) and skeleton (B). Preferable examples of R³ are as described above. For example, if R³ in the desired skeleton (A) and skeleton (B) is a phenylene group optionally having a substituent, an isophthalic acid (chloride) optionally having a substituent or a terephthalic acid (chloride) optionally having a substituent may be used.

### -Monovalent hydroxy compound (x3) having aromatic hydroxy group-

The component (x3) is a monovalent hydroxy compound having an aromatic hydroxy group and is represented by the following formula (5).
[Chem. 10]

**R^{1a}-OH** **(5)**

(in the formula, R^{1a} is as described above)

As the component (x3), any aromatic monool may be used as long as the desired structure of the polyester resin is achieved. Preferable examples of R^{1a} are as described above. For example, as such an aromatic monool, if the monovalent aromatic group R¹ in the desired skeleton (A) is a naphthyl group optionally having a substituent, a naphthol optionally having a substituent may be used, and if the monovalent aromatic group R¹ in the desired skeleton (A) is a phenyl group optionally having a substituent, a phenol optionally having a substituent may be used.

In the condensation reaction of the component (x1), the component (x2) and the component (x3), condensation (esterification) proceeds between the component (x2) and the component (x1) and between the component (x2) and the component (x3). In such a reaction, a condensation degree between the component (x2) and the component (x1) can be adjusted by changing a condition such as the amount ratio of each component, whereby the structure of the resulting polyester resin (the repeating number N in the formula (1)) can be adjusted.

The condensation reaction may be proceeded in a solvent-free system without using a solvent or in an organic solvent system using an organic solvent. Examples of the organic solvent used in the condensation reaction may include: a ketone-based solvent such as acetone, methyl ethyl ketone, methyl isobutyl ketone, and cyclohexanone; an acetic ester-based solvent such as ethyl acetate, butyl acetate, cellosolve acetate, propylene glycol monomethyl ether acetate, and carbitol acetate; a carbitol-based solvent such as cellosolve and butyl carbitol; an aromatic hydrocarbon solvent such as toluene and xylene; and an amide-based solvent such as N,N-dimethylformamide, N,N-dimethylacetamide, and N-methyl-2-pyrrolidone. As the organic solvent, one type thereof may be solely used, and two or more types thereof may also be used in combination.

A base may be used in the condensation reaction. Examples of the base may include: an alkali metal hydroxide such as sodium hydroxide (caustic soda) and potassium hydroxide; and a tertiary amine such as triethylamine, pyridine, and N,N-dimethyl-4-aminopyridine (DMAP). As the base, one type thereof may be solely used, and two or more types thereof may also be used in combination.

A condensation agent and a phase transfer catalyst may also be used in the condensation reaction. As these agents, any conventionally known agents that can be used in the esterification reaction may be used.

The reaction temperature in the condensation reaction is not particularly limited as long as the condensation reaction is proceeded. For example, the reaction temperature may be in a range of 0 to 80°C. Furthermore, the reaction time in the condensation reaction is not particularly limited as long as the desired structure of the polyester resin is achieved. For example, the reaction time may be in a range of 30 minutes to 8 hours.

The polyester resin may be purified after the condensation reaction. For example, a purification step such as washing with water or microfiltration may be performed after the condensation reaction to remove by-product salts and excessive starting materials from the system. Specifically, after the condensation reaction, water is added in an amount necessary for dissolving the by-product salts, and an aqueous layer obtained by static liquid separation is discarded. Furthermore, an acid is added as needed for neutralization, and washing with water is repeated. Then, a dehydration process is performed using a chemical agent or by azeotropic distillation, followed by microfiltration to remove impurities for purification. Subsequently, as necessary, the organic solvent is removed by distillation to obtain the polyester resin. The organic solvent may not be completely removed and the remaining organic solvent may be used as it is as a solvent for the resin composition.

The polyester resin of the present invention can achieve a cured product exhibiting excellent dielectric properties and favorable chemical resistance in combination with the cross-linkable resin. Furthermore, the polyester resin of the present invention can achieve the cured product with favorable chemical resistance and, as a result, suppress the occurrence of a crack defect or an interfacial delamination defect, even if the blending ratio (mass ratio) of the polyester resin relative to the cross-linkable resin is increased to achieve the transmission loss required for 5G applications. Thus, in a preferred embodiment, the polyester resin of the present invention can be suitably used as a resin cross-linking agent.

### [Resin composition]

The polyester resin of the present invention can be used to produce a resin composition. The present invention also provides such a resin composition.

The resin composition of the present invention includes a polyester resin (X) and a cross-linkable resin (Y), and the polyester resin (X) is the polyester resin of the present invention, that is, the polyester resin containing both the following skeleton (A) and skeleton (B) :
<Skeleton (A)> a skeleton represented by the formula: (-)R¹-O-C(=O)-R³-: and
<Skeleton (B)> a skeleton represented by the formula: -R²-O-C(=O)-R³-
(in the formulas,
   R¹ represents a monovalent or divalent aromatic group,
   R² represents a divalent aliphatic group, and
   R³ represents a divalent aromatic group).

Preferred examples of the skeleton (A) and the skeleton (B), a preferred range of the equivalent weight of oxycarbonyl groups, a preferred embodiment of the structural units and general formulas, and details of the polyester resin (X) are as described in the section of [Polyester resin].

In the resin composition of the present invention, the type of the cross-linkable resin (Y) is not particularly limited as long as it can be crosslinked in combination with the polyester resin (X). The cross-linkable resin (Y) is preferably one or more types selected from the group consisting of a thermosetting resin and a radically polymerizable resin from the viewpoint of achieving a cured product exhibiting excellent dielectric properties and favorable chemical resistance in combination with the polyester resin (X).

As the thermosetting resin and the radically polymerizable resin, known resins used in forming an insulating layer for the printed wiring board or the semiconductor chip package may be used. Hereinafter, a thermosetting resin and a radically polymerizable resin that can be used as the cross-linkable resin (Y) will be described.

Examples of the thermosetting resin may include an epoxy resin, a benzocyclobutene resin, an epoxy acrylate resin, a urethane acrylate resin, a urethane resin, a cyanate resin, a polyimide resin, a benzoxazine resin, an unsaturated polyester resin, a phenol resin, a melamine resin, a silicone resin, and a phenoxy resin. As the thermosetting resin, one type thereof may be solely used, and two or more types thereof may also be used in combination. Among these, the cross-linkable resin (Y) preferably includes an epoxy resin from the viewpoint of achieving a cured product that is more excellent in both dielectric properties and chemical resistance in combination with the polyester resin (X).

The type of the epoxy resin is not particularly limited as long as it has one or more (preferably two or more) epoxy groups within one molecule. Examples of the epoxy resin may include a bisphenol A type epoxy resin, a bisphenol F type epoxy resin, a bisphenol S type epoxy resin, a bisphenol AF type epoxy resin, a phenol novolac type epoxy resin, a tert-butyl-catechol type epoxy resin, a naphthol type epoxy resin, a naphthalene type epoxy resin, a naphthylene ether type epoxy resin, a glycidyl amine type epoxy resin, a glycidyl ester type epoxy resin, a cresol novolac type epoxy resin, a biphenyl type epoxy resin, a phenol aralkyl type epoxy resin, a biphenyl aralkyl type epoxy resin, a fluorene-skeleton type epoxy resin, a dicyclopentadiene type epoxy resin, an anthracene type epoxy resin, a linear aliphatic epoxy resin, an epoxy resin having a butadiene structure, an alicyclic epoxy resin, a heterocyclic epoxy resin, a spirocyclic epoxy resin, a cyclohexanedimethanol type epoxy resin, a trimethylol type epoxy resin, and a halogenated epoxy resin. According to the resin composition of the present invention containing the polyester resin (X), it is possible to achieve a cured product exhibiting excellent dielectric properties and favorable chemical resistance regardless of the type of the epoxy resin.

The epoxy resin may be classified into epoxy resins in a liquid state at a temperature of 20°C (hereinafter referred to as a "liquid epoxy resin") and epoxy resins in a solid state at a temperature of 20°C (hereinafter referred to as a "solid epoxy resin"), and the resin composition of the present invention may contain only a liquid epoxy resin as the cross-linkable resin (Y), may contain only a solid epoxy resin, or may contain a combination of a liquid epoxy resin and a solid epoxy resin. When a combination of a liquid epoxy resin and a solid epoxy resin is contained, the blending ratio (liquid : solid) may be in the range of 20:1 to 1:20 by mass ratio (preferably 10:1 to 1:10, more preferably 3:1 to 1:3).

The equivalent weight of the epoxy group of the epoxy resin is preferably 50 g/eq. to 2000 g/eq., more preferably 60 g/eq. to 1000 g/eq., and further preferably 80 g/eq. to 500 g/eq. The equivalent weight of the epoxy group is a mass of the epoxy resin containing one equivalent of epoxy groups and may be measured according to JIS K7236.

The weight-average molecular weight (Mw) of the epoxy resin is preferably 100 to 5,000, more preferably 250 to 3,000, and further preferably 400 to 1,500. Mw of the epoxy resin may be measured as a polystyrene equivalent value by a GPC method.

The type of the radically polymerizable resin is not particularly limited as long as it has one or more (preferably two or more) radically polymerizable unsaturated groups within one molecule. Examples of the radically polymerizable resin may include resins containing, as a radically polymerizable unsaturated group, one or more types selected from a maleimide group, a vinyl group, an allyl group, a styryl group, a vinylphenyl group, an acryloyl group, a methacryloyl group, a fumaroyl group, and a maleoyl group. Among these, the cross-linkable resin (Y) preferably contains one or more types selected from a maleimide resin, a (meth)acrylic resin, and a styryl resin, from the viewpoint of achieving a cured product that is more excellent in both dielectric properties and chemical resistance in combination with the polyester resin (X).

The type of the maleimide resin is not particularly limited as long as it has one or more (preferably two or more) maleimide groups (2,5-dihydro-2,5-dioxo-1H-pyrrol-1-yl group) within one molecule. Examples of the maleimide resin may include a maleimide resin containing an aliphatic skeleton of 36 carbon atoms derived from a dimer diamine, such as "BMI-3000J", "BMI-5000", "BMI-1400", "BMI-1500", "BMI-1700", and "BMI-689" (all manufactured by Designer Molecules Inc.); a maleimide resin containing an indane skeleton described in Journal of Technical Disclosure No. 2020-500211 published by Japan Institute for Promoting Invention and Innovation; and a maleimide resin containing an aromatic ring skeleton directly bonded to a nitrogen atom of a maleimide group such as "MIR-3000-70MT" (manufactured by Nippon Kayaku Co., Ltd.), "BMI-4000" (manufactured by Daiwa Fine Chemicals Co., Ltd.), and "BMI-80" (manufactured by K-I Chemical Industry CO., LTD.).

The type of the (meth)acrylic resin is not particularly limited as long as it has one or more (preferably two or more) (meth)acryloyl groups within one molecule. Herein, the term "(meth)acryloyl group" is a generic term for an acryloyl group and a methacryloyl group. Examples of the methacrylic resin may include (meth)acrylic resins such as "A-DOG" (manufactured by Shin-Nakamura Chemical Co., Ltd.), "DCP-A" (manufactured by Kyoeisha Chemical Co., Ltd.), "NPDGA", "FM-400", "R-687", "THE-330", "PET-30", and "DPHA" (all manufactured by Nippon Kayaku Co., Ltd.).

The type of the styryl resin is not particularly limited as long as it has one or more (preferably two or more) styryl groups or vinylphenyl groups within one molecule. Examples of the styryl resin may include styryl resins such as "OPE-2St", "OPE-2St 1200", and "OPE-2St 2200" (all manufactured by Mitsubishi Gas Chemical Co., Inc.).

The resin composition of the present invention may contain only a thermosetting resin, only a radically polymerizable resin, or a combination of a thermosetting resin and a radically polymerizable resin, as the cross-linkable resin (Y).

In the resin composition of the present invention, the mass ratio ((X)/(Y)) of the polyester resin (X) to the cross-linkable resin (Y) may be 1 or more, preferably 1.1 or more, and more preferably 1.2 or more. With the polyester resin (X) containing both the skeleton (A) and the skeleton (B), even if the blending ratio (mass ratio) to the cross-linkable resin is increased to the above-mentioned range, a cured product having favorable chemical resistance can be produced, and the transmission loss required for 5G applications can be achieved while occurrence of a crack defect or an interfacial delamination defect can be suppressed. The upper limit of the mass ratio ((X)/(Y)) may be, for example, 2 or less, 1.9 or less, or 1.8 or less. Thus, in an embodiment, the mass ratio ((X)/(Y)) of the polyester resin (X) to the cross-linkable resin (Y) is 1.2 to 2.0.

The resin composition of the present invention may further include an inorganic filler. When the resin composition includes the inorganic filler, the coefficient of linear thermal expansion and the dielectric loss tangent can be further reduced.

Examples of the inorganic filler may include silica, alumina, barium sulfate, talc, clay, mica powder, aluminum hydroxide, magnesium hydroxide, calcium carbonate, magnesium carbonate, magnesium oxide, boron nitride, aluminum borate, barium titanate, strontium titanate, calcium titanate, magnesium titanate, bismuth titanate, titanium oxide, barium zirconate, and calcium zirconate. Among these, silica is preferable. Examples of the silica may include amorphous silica, fused silica, crystalline silica, synthetic silica, and hollow silica. As silica, spherical silica is preferable. As the inorganic filler, one type thereof may be solely used, and two or more types thereof may also be used in combination. Examples of commercially available products of the inorganic filler may include "UFP-30" (manufactured by Denka Co., Ltd.); "YC100C", "YA050C", "YA050C-MJE", "YA010C", "SC2500SQ", "SO-C4", "SO-C2", "SO-C1", and "SC-C2" (all manufactured by Admatechs Co., Ltd.); "Silfil NSS-3N", "Silfil NSS-4N", and "Silfil NSS-5N" (manufactured by Tokuyama Corp.).

The average particle diameter of the inorganic filler is preferably 5 µm or less, more preferably 2 µm or less, and further preferably 1 µm or less from the viewpoint of making the surface of the cured product (insulating layer) low roughness and facilitating fine wiring formation. The lower limit of the average particle diameter is not particularly limited, and may be, for example, 0.01 µm or more, 0.02 µm or more, or 0.03 µm or more. The average particle diameter of the inorganic filler may be measured by a laser diffraction scattering method based on the Mie scattering theory. Specifically, the average particle diameter may be measured by creating a particle size distribution of the inorganic filler on a volume basis by a laser diffraction scattering particle size distribution measuring apparatus, and using the obtained median diameter as the average particle diameter. As the measurement sample, an inorganic filler dispersed in water by ultrasonic waves may be preferably used. The laser diffraction scattering particle size distribution measuring apparatus to be used may include LA-950 manufactured by Horiba, Ltd. or the like.

The inorganic filler is preferably one obtained by performing a surface treatment with a surfaced treating agent, such as an aminosilane-based coupling agent, a ureidosilane-based coupling agent, an epoxy-silane-based coupling agent, a mercaptosilane-based coupling agent, a vinylsilane-based coupling agent, a styrylsilane-based coupling agent, an acrylate-silane-based coupling agent, an isocyanate-silane-based coupling agent, a sulfide silane-based coupling agent, an organosilazane compound, or a titanate-based coupling agent, to improve its moisture resistance and dispersibility.

When the resin composition of the present invention includes an inorganic filler, the content of the inorganic filler in the resin composition may be determined according to the properties required for the resin composition. When the nonvolatile component in the resin composition is defined as 100% by mass, for example, the content thereof is 5% by mass or more, 10% by mass or more, preferably 30% by mass or more, more preferably 40% by mass or more, and further preferably 50% by mass or more. The upper limit of the content of the inorganic filler is not particularly limited, and may be, for example, 90% by mass or less, and 80% by mass or less.

The resin composition of the present invention may further contain a resin crosslinking agent other than the polyester resin (X).

Examples of resin cross-linking agents other than the polyester resin (X) may include a phenol-based curing agent, such as "TD2090" and "TD2131" (manufactured by DIC Corp.), "MEH-7600", "MEH-7851", and "MEH-8000H" (manufactured by Meiwa Plastic Industries, Ltd.), "NHN", "CBN", "GPH-65", and "GPH-103" (manufactured by Nippon Kayaku Co., Ltd.), "SN170", "SN180", "SN190", "SN475", "SN485", "SN495", "SN375", and "SN395" (manufactured by Nippon Steel Chemical & Materials Co., Ltd.), and "LA7052", "LA7054", "LA3018", and "LA1356" (manufactured by DIC Corp.); a benzoxazine-based crosslinking agent such as "F-a" and "P-d" (manufactured by Shikoku Chemicals Corp.), and "HFB2006M" (manufactured by Showa Highpolymer Co., Ltd.); an acid anhydride crosslinking agent such as methylhexahydrophthalic anhydride, methylnadic anhydride, and hydrogenated methylnadic anhydride; a cyanate ester-based crosslinking agent such as PT30, PT60, and BA230S75 (manufactured by LONZA K.K.); and a benzoxazine-based crosslinking agent.

When the resin composition of the present invention includes a resin crosslinking agent other than the polyester resin (X), the content of the resin crosslinking agent in the resin composition may be determined according to the properties required for the resin composition. When the nonvolatile component in the resin composition is defined as 100% by mass, the content thereof is preferably 40% by mass or less, more preferably 20% by mass or less, and further preferably 10% by mass or less, and the lower limit thereof is 0.01% by mass or more, 0.05% by mass or more, and 0.1% by mass or more.

The resin composition of the present invention may further contain a crosslinking accelerator. By containing the crosslinking accelerator, the crosslinking time and the crosslinking temperature can be efficiently adjusted.

Examples of the crosslinking accelerator may include an organophosphine compound such as "TPP", "TPP-K", and "TPTP-S" (manufactured by Hokko Chemical Industry Co., Ltd.); an imidazole compound such as "Cuazole 2MZ", "2E4MZ", "Cl1Z", "Cl1Z-CN", "Cl1Z-CNS", "Cl1Z-A", "2MZ-OK", "2MA-OK", and "2PHZ" (manufactured by Shikoku Chemicals Corp.); an amine adduct compound such as Novacure (manufactured by Asahi Kasei Corp.) and Fijicure (manufactured by Fuji Kasei Kogyo Co., Ltd.); an amine compound such as 1,8-diazabicyclo[5,4,0]undecene-7,4-dimethylaminopyridine, benzyldimethylamine, 2,4,6-tris(dimethylaminomethyl)phenol, and 4-dimethylaminopyridine; and organometallic complexes or organometallic salts of such as cobalt, copper, zinc, iron, nickel, manganese, tin, and the like.

When the resin composition of the present invention includes a crosslinking accelerator, the content of the crosslinking accelerator in the resin composition may be determined according to the properties required for the resin composition. When the non-volatile component in the resin composition is defined as 100% by mass, the content thereof is preferably 10% by mass or less, more preferably 5% by mass or less, and further preferably 1% by mass or less, and the lower limit thereof is 0.001% by mass or more, 0.01% by mass or more, and 0.05% by mass or more.

The resin composition of the present invention may further contain an optional additive. Examples of the additive may include an organic filler such as rubber particles; a radical polymerization initiator such as a peroxide-based radical polymerization initiator and an azo-based radical polymerization initiator; a thermoplastic resin such as a phenoxy resin, a polyvinyl acetal resin, a polysulfone resin, a polyether sulfone resin, a polyphenylene ether resin, a polyether ether ketone resin, and a polyester resin; an organometallic compound such as an organocopper compound, an organozinc compound, and an organocobalt compound; a colorant such as phthalocyanine blue, phthalocyanine green, iodine green, diazo yellow, crystal violet, titanium oxide, and carbon black; a polymerization inhibitor such as hydroquinone, catechol, pyrogallol, and phenothiazine; a leveling agent such as a silicone-based leveling agent and an acrylic polymer-based leveling agent; a thickener such as bentone and montmorillonite; a defoamer such as a silicon-based defoamer, an acrylic-based defoamer, a fluorine-based defoamer, and a vinyl-based defoamer; a UV absorber such as a benzotriazole-based UV absorber; an adhesion improver such as urea silane; an adhesion imparting agent such as a triazole-based adhesion imparting agent, a tetrazole-based adhesion imparting agent, and a triazine-based adhesion imparting agent; an antioxidant such as a hindered phenol-based antioxidant; a fluorescent brightener such as a stilbene derivative; a surfactant such as a fluorine-based surfactant and a silicone-based surfactant; a flame retardant such as a phosphorus-based flame retardant (e.g., a phosphate ester compound, a phosphazene compound, a phosphinic acid compound, and red phosphorus), a nitrogen-based flame retardant (e.g., melamine sulfate), a halogen-based flame retardant, and an inorganic flame retardant (e.g., antimony trioxide); a dispersant such as a phosphate-based dispersant, a polyoxyalkylene-based dispersant, an acetylene-based dispersant, a silicone-based dispersant, an anionic dispersant, and a cationic dispersant; and a stabilizer such as a borate-based stabilizer, a titanate-based stabilizer, an aluminate-based stabilizer, a zirconate-based stabilizer, an isocyanate-based stabilizer, a carboxylic acid-based stabilizer, and a carboxylic anhydride-based stabilizer. The content of such additives may be determined according to the properties required for the resin composition.

The resin composition of the present invention may further contain an organic solvent as a volatile component. Examples of the organic solvent may include: a ketone-based solvent such as acetone, methyl ethyl ketone, methyl isobutyl ketone, and cyclohexanone; an ester-based solvent such as methyl acetate, ethyl acetate, butyl acetate, isobutyl acetate, isoamyl acetate, methyl propionate, ethyl propionate, and γ-butyrolactone; an ether-based solvent such as tetrahydropyran, tetrahydrofuran, 1,4-dioxane, diethyl ether, diisopropyl ether, dibutyl ether, and diphenyl ether; an alcohol-based solvent such as methanol, ethanol, propanol, butanol, and ethylene glycol; an ether ester-based solvent such as 2-ethoxyethyl acetate, propylene glycol monomethyl ether acetate, diethylene glycol monoethyl ether acetate, ethyl diglycol acetate, γ-butyrolactone, and methyl methoxypropionate; an ester alcohol-based solvent such as methyl lactate, ethyl lactate, and methyl 2-hydroxyisobutyrate; an ether alcohol-based solvent such as 2-methoxypropanol, 2-methoxyethanol, 2-ethoxyethanol, propylene glycol monomethyl ether, and diethylene glycol monobutyl ether (butyl carbitol); an amide-based solvent such as N,N-dimethylformamide, N,N-dimethylacetamide, and N-methyl-2-pyrrolidone; a sulfoxide-based solvent such as dimethyl sulfoxide; a nitrile-based solvent such as acetonitrile and propionitrile; an aliphatic hydrocarbon-based solvent such as hexane, cyclopentane, cyclohexane, and methylcyclohexane; and an aromatic hydrocarbon-based solvent such as benzene, toluene, xylene, ethylbenzene, and trimethylbenzene. As the organic solvent, one type thereof may be solely used, and two or more types thereof may also be used in combination.

When the resin composition of the present invention contains an organic solvent, the content of the organic solvent in the resin composition may be determined according to the properties required for the resin composition. When all the components in the resin composition are defined as 100% by mass, for example, the content thereof may be set to 60% by mass or less, 40% by mass or less, 30% by mass or less, 20% by mass or less, 150 by mass or less, 10% by mass or less, or the like.

The resin composition of the present invention may be prepared by appropriately mixing the necessary components among the above-mentioned components, and kneading or mixing by a kneading means such as a three-roll roll, a ball mill, a bead mill, a sand mill, or the like, or a stirring means such as a super mixer, a planetary mixer, or the like as necessary.

The resin composition of the present invention, which includes the polyester resin (X) and the crosslinkable resin (Y) in combination, can achieve the cured product exhibiting excellent dielectric properties and favorable chemical resistance.

In an embodiment, the cured product of the resin composition of the present invention has a characteristic of having a low dielectric constant (Dk). For example, the dielectric constant (Dk) of the cured product of the resin composition of the present invention can be preferably 3.0 or less, 2.9 or less, or 2.8 or less, when measured at 5.8 GHz and 23°C as described in the section of [Dielectric properties] below.

In an embodiment, the cured product of the resin composition of the present invention has a characteristic of having a low dielectric loss tangent (Df). For example, the dielectric loss tangent (Df) of the cured product of the resin composition of the present invention can be preferably 0.01 or less, 0.008 or less, 0.0075 or less, or 0.007 or less, when measured at 5.8 GHz and 23°C as described in the section of [Dielectric properties] below.

In an embodiment, the cured product of the resin composition of the present invention has a characteristic of having high chemical resistance (alkali resistance and acid resistance). For example, a weight change ratio of the cured product of the resin composition of the present invention can be preferably 1% or less, 0.8% or less, 0.6% or less, 0.5% or less, or 0.4% or less, when immersed in a 10% by weight sodium hydroxide aqueous solution or 10% by weight sulfuric acid at 40°C for 24 hours as described in the section of [Chemical resistance] below. Furthermore, a strength change ratio can also be preferably 1% or less, 0.8% or less, 0.6% or less, 0.5% or less, or 0.4% or less.

Furthermore, even if the blending ratio (mass ratio) of the polyester resin (X) relative to the crosslinkable resin (Y) is high, the resin composition of the present invention can achieve the cured product with favorable chemical resistance, making it possible to suppress the occurrence of a crack defect and an interfacial delamination defect while achieving the transmission loss required for 5G applications. Thus, the resin composition of the present invention can be suitably used as a resin composition for forming an insulation layer of the printed wiring board (resin composition for an insulation layer of printed wiring board), more suitably used as a resin composition for forming an interlayer insulation layer of the printed wiring board (resin composition for an interlayer insulation layer of printed wiring board). The resin composition of the present invention can also be suitably used in a case where the printed wiring board is a component-embedded circuit board. The resin composition of the present invention can also be suitably used as a resin composition for sealing a semiconductor chip (resin composition for sealing semiconductor). The resin composition capable of significantly reducing a delamination defect with a via or a wiring pattern can be suitably used as a resin composition for the redistribution forming layer as an insulation layer for forming the redistribution layer (resin composition for a redistribution forming layer). The resin composition of the present invention can also be used in a wide range of applications where a resin composition is required, such as a sheet-like laminated material such as a resin sheet or a prepreg, a solder resist, an underfill material, a die bonding material, a hole-filling resin, and a component-embedding resin.

### [Sheet-like laminated material (resin sheet and prepreg)]

The resin composition of the present invention can also be used for application in the form of varnish. However, it is suitably used in the form of a sheet-like laminated material including the resin composition.

As the sheet-like laminated material, the following resin sheet and prepreg are preferable.

In an embodiment, the resin sheet includes a support and a layer of the resin composition disposed on the support (hereinafter, simply referred to as "resin composition layer"), and the resin composition layer is formed of the resin composition of the present invention.

The thickness of the resin composition layer varies in preferable values depending on applications and may be appropriately determined according to the applications. For example, the thickness of the resin composition layer is preferably 200 µm or less, more preferably 150 µm or less, 120 µm or less, 100 µm or less, 80 µm or less, 60 µm or less, or 50 µm or less, from the viewpoint of reducing the thickness of the printed wiring board or the semiconductor chip package. Although the lower limit of the thickness of the resin composition layer is not particularly limited, it can be usually 1 µm or more, 5 µm or more, or the like.

Examples of the support may include a film made of a plastic material, a metal foil, and a release paper. Of these, a film made of a plastic material and a metal foil are preferable.

In a case where a film made of a plastic material is used as the support, examples of the plastic material may include a polyester such as a polyethylene terephthalate (PET) and a polyethylene naphthalate (PEN), an acrylic resin such as a polycarbonate (PC) and a polymethyl methacrylate (PMMA), a cyclic polyolefin, a triacetyl cellulose (TAC), a polyether sulfide (PES), a polyether ketone, and a polyimide. Of these, a polyethylene terephthalate and a polyethylene naphthalate are preferable, and an inexpensive polyethylene terephthalate is particularly preferable.

In a case where a metal foil is used as the support, examples of the metal foil may include a copper foil and an aluminum foil. Of these, the copper foil is preferable. As the copper foil, a foil made of a single metal of copper may be used, or a foil made of an alloy of copper and different metal (e.g., tin, chromium, silver, magnesium, nickel, zirconium, silicon, titanium, etc.) may be used.

The support may be subjected to a matte treatment, a corona treatment, and an antistatic treatment on the surface to be bonded to the resin composition layer. Furthermore, as the support, a support with release layer having a release layer on the surface to be bonded to the resin composition layer may be used. A release agent used in the release layer of the support with release layer may be one or more release agents selected from the group consisting of an alkyd resin, a polyolefin resin, a urethane resin, and a silicone resin. A commercially available product may be used as the support with release layer. Examples thereof may include "SK-1", "AL-5", and "AL-7" manufactured by Lintec Corp., which are a PET film with a release layer including an alkyd resin-based release agent as a main component, "LUMIRROR T60" manufactured by Toray Industries, Inc., "PUREX" manufactured by Teijin Ltd., and "UNIPEEL" manufactured by Unitika Ltd.

The thickness of the support is not particularly limited. However, the thickness is preferably in a range of 5 µm to 75 µm, more preferably in a range of 10 µm to 60 µm. Note that, in a case where the support with release layer is used, the thickness of the support with release layer as a whole is preferably within the above-mentioned range.

As the support, a metal foil with supporting substrate, in which a peelable supporting substrate is bonded to a thin metal foil, may also be used. In an embodiment, the metal foil with supporting substrate includes a supporting substrate, a release layer disposed on the supporting substrate, and a metal foil disposed on the releasing layer. In a case where the metal foil with supporting substrate is used as the support, the resin composition layer is disposed on the metal foil.

In the metal foil with supporting substrate, a material of the supporting substrate is not particularly limited. However, examples of the material may include a copper foil, an aluminum foil, a stainless-steel foil, a titanium foil, and a copper alloy foil. In a case where a copper foil is used as the supporting substrate, an electrolytic copper foil or a rolled copper foil may be used. Furthermore, the release layer is not particularly limited as long as the metal foil can be released from the supporting substrate. Examples of the release layer may include: an alloy layer of elements selected from the group consisting of Cr, Ni, Co, Fe, Mo, Ti, W, and P; and an organic film.

In the metal foil with supporting substrate, preferable examples of a material of the metal foil may include a copper foil and a copper alloy foil.

In the metal foil with supporting substrate, the thickness of the supporting substrate is not particularly limited. However, the thickness is preferably in a range of 10 µm to 150 µm, more preferably in a range of 10 µm to 100 µm. Furthermore, the thickness of the metal foil may be, for example, in a range of 0.1 µm to 10 µm.

In an embodiment, the resin sheet may further include an optional layer as necessary. Examples of such an optional layer may include a protective film disposed on the surface of the resin composition layer, which is not bonded to the support (i.e., the surface on the opposite side to the support). The thickness of the protective film is not particularly limited. However, the thickness is, for example, 1 µm to 40 µm. Laminating the protective film can prevent the surface of the resin composition layer from being dusted or scratched.

The resin sheet can be produced by, for example, using the liquid resin composition as it is or preparing a resin varnish by dissolving the resin composition in an organic solvent, applying such a resin composition onto the support using a die coater or the like, and then drying the resin composition to form a resin composition layer.

Examples of the organic solvent may include the same organic solvents described as the component of the resin composition. As the organic solvent, one type thereof may be solely used, and two or more types thereof may also be used in combination.

The drying may be performed by a known method such as heating or blowing with hot air. Although a drying condition is not particularly limited, the drying is performed so that the content of the organic solvent in the resin composition layer is reduced to 10% by mass or less, preferably 5% by mass or less. The drying condition varies depending on the boiling point of the organic solvent in the resin composition or the resin varnish. For example, in a case where the resin composition or the resin varnish including 30% by mass to 60% by mass of the organic solvent is used, the resin composition layer can be formed by drying the resin composition or the resin varnish at 50°C to 150°C for 3 minutes to 10 minutes.

The resin sheet can be wound into a roll and stored. In a case where the resin sheet has a protective film, the resin sheet can be used by peeling off the protective film.

In an embodiment, the prepreg is formed by impregnating a sheet-like fiber substrate with the resin composition of the present invention.

The sheet-like fiber substrate used for the prepreg is not particularly limited. A material commonly used as a substrate for prepreg, such as glass cloth, aramid nonwoven fabric, or liquid crystal polymer nonwoven fabric, can be used. From the viewpoint of reducing the thickness of the printed wiring board or the semiconductor chip package, the thickness of the sheet-like fiber substrate is preferably 50 µm or less, more preferably 40 µm or less, further preferably 30 µm or less, and particularly preferably 20 µm or less. The lower limit of the thickness of the sheet-like fiber substrate is not particularly limited. However, it is usually 10 µm or more.

The prepreg can be produced by a known method such as a hot melt method and a solvent method.

The thickness of the prepreg can be in the same range as the resin composition layer in the resin sheet described above.

The sheet-like laminated material of the present invention can be suitably used for forming an insulation layer of the printed wiring board (for an insulation layer of printed wiring board), and more suitably used for forming an interlayer insulation layer of the printed wiring board (for an interlayer insulation layer of printed wiring board). The sheet-like laminated material of the present invention can also be suitably used for sealing the semiconductor chip (for sealing semiconductor). The sheet-like laminated material capable of significantly reducing a delamination defect with a via or a wiring pattern can be suitably used for a redistribution forming layer as an insulation layer for forming the redistribution layer.

### [Printed wiring board]

The printed wiring board of the present invention includes the insulation layer formed of the cured product of the resin composition of the present invention.

The printed wiring board can be produced by, for example, a method including the following steps (I) and (II) using the above-mentioned resin sheet:
(I) a step of laminating a resin sheet on an inner layer substrate so that a resin composition layer of the resin sheet is bonded to the inner layer substrate; and
(II) a step of curing (e.g., thermally -curing) the resin composition layer to form an insulation layer.

The "inner layer substrate" used in the step (I) is a member that serves as a substrate of the printed wiring board. Examples of the inner layer substrate may include a glass epoxy substrate, a metal substrate, a polyester substrate, a polyimide substrate, a BT resin substrate, and a thermosetting polyphenylene ether substrate. Furthermore, such a substrate may have a conductor layer on one or both surfaces, and this conductor layer may be patterned. The inner layer substrate having the conductor layer (circuit) formed on one or both surfaces of the substrate is sometimes referred to as an "inner layer circuit substrate". Furthermore, an intermediate product on which the insulation layer and/or the conductive layer are to be formed in the production of the printed wiring board is also included in the "inner layer substrate" as defined in the present invention. In a case where the printed wiring board is a component-embedded circuit board, an inner layer substrate having components embedded may be used.

The lamination of the inner layer substrate and the resin sheet can be performed by, for example, thermocompression bonding of the resin sheet to the inner layer substrate carried out from the support side. Examples of a member for use in performing the thermocompression bonding of the resin sheet to the inner layer substrate (hereinafter also referred to as "thermocompression bonding member") may include a heated metal plate (a SUS head plate, etc.) and a heated metal roll (a SUS roll). Note that the thermocompression bonding member may be directly pressed onto the resin sheet or may be pressed through an elastic material such as heat-resistant rubber so that the resin sheet sufficiently follows the uneven surface of the inner layer substrate.

The lamination of the inner layer substrate and the resin sheet may be performed by a vacuum lamination method. In the vacuum lamination method, the thermocompression bonding temperature is preferably in a range of 60°C to 160°C, more preferably 80°C to 140°C, the thermocompression bonding pressure is preferably in a range of 0.098 MPa to 1.77 MPa, more preferably 0.29 MPa to 1.47 MPa, and the thermocompression bonding time is preferably in a range of 20 seconds to 400 seconds, more preferably 30 seconds to 300 seconds. The lamination can be performed under a reduced pressure condition, preferably at a pressure of 26.7 hPa or less.

The lamination can be performed with a commercially available vacuum laminator. Examples of the commercially available vacuum laminator may include a vacuum pressure laminator manufactured by Meiki Co., Ltd., and a vacuum applicator and a batch type vacuum pressure laminator manufactured by Nikko-Materials Co., Ltd.

After the lamination, the laminated resin sheet may be subjected to a smoothing treatment by, for example, pressing the laminated resin sheet from the support side with the thermocompression member under normal pressure (atmospheric pressure). A pressing condition for the smoothing treatment can be the same as the condition for the thermocompression bonding used for the lamination described above. The smoothing treatment can be performed with a commercially available laminator. Note that the lamination and the smoothing treatment may be performed successively using the commercially available vacuum laminator described above.

The support may be removed between the step (I) and the step (II) or may be removed after the step (II). Note that, in a case where a metal foil is used as the support, the conductive layer may be formed using the metal foil without peeling off the support. Furthermore, in a case where a metal foil with supporting substrate is used as the support, the supporting substrate (and the release layer) is simply peeled off. Then, a conductive layer can be formed using the metal foil.

In the step (II), the resin composition layer is cured (e.g., thermally cured) to form an insulation layer formed of a cured product of the resin composition. A curing condition for the resin composition layer is not particularly limited, and the condition usually employed for forming an insulation layer of the printed wiring board may be used.

The thermal curing condition for the resin composition layer varies depending on the type of the resin composition and the like. However, for example, in an embodiment, the curing temperature is preferably 120°C to 250°C, more preferably 150°C to 240°C, and further preferably 180°C to 230°C. The curing time can be preferably 5 minutes to 240 minutes, more preferably 10 minutes to 150 minutes, and further preferably 15 minutes to 120 minutes.

Before being thermally cured, the resin composition layer may be preheated at a temperature lower than the curing temperature. For example, before being thermally cured, the resin composition layer may be preheated at a temperature of 50°C to 120°C, preferably 60°C to 115°C, more preferably 70°C to 110°C for 5 minutes or more, preferably 5 minutes to 150 minutes, more preferably 15 minutes to 120 minutes, and further preferably 15 minutes to 100 minutes.

In the production of the printed wiring board, a step (III) of perforating the insulation layer, a step (IV) of subjecting the insulation layer to a roughening treatment, and a step (V) of forming a conductive layer may be further performed. These steps (III) to (V) may be performed according to various methods known to those skilled in the art used in the production of the printed wiring board. Note that, in a case where a support is removed after the step (II), the support may be removed between the step (II) and the step (III), between the step (III) and the step (IV), or between the step (IV) and the step (V). Furthermore, if necessary, the steps (I) to (V) of forming the insulation layer and the conductive layer may be repeated to form a multilayer wiring board.

In another embodiment, the printed wiring board of the present invention can be produced using the prepreg described above. A production method is basically the same as the method using the resin sheet.

The step (III) is a step of perforating the insulation layer, whereby a hole such as a via hole or a through hole can be formed in the insulation layer. The step (III) may be performed using, for example, a drill, laser, plasma, or the like, depending on the composition and the like of the resin composition used for forming the insulation layer. The dimension and shape of the hole may be appropriately determined according to a design of the printed wiring board.

The step (IV) is a step of subjecting the insulation layer to a roughening treatment. Usually, removal of smear (desmear) is also performed in this step (IV). A procedure and condition for the roughening treatment are not particularly limited, and a known procedure and condition that are commonly used for forming an insulation layer of the printed wiring board can be employed. For example, the roughening treatment of the insulation layer can be performed by carrying out a swelling treatment with a swelling liquid, a roughening treatment with an oxidizing agent, and a neutralizing treatment with a neutralizing liquid, in this order.

The swelling liquid used for the roughening treatment is not particularly limited. However, examples thereof may include an alkaline solution and a surfactant solution. Of these, an alkaline solution is preferable. As the alkaline solution, a sodium hydroxide solution and a potassium hydroxide solution are more preferable. Examples of a commercially available swelling liquid may include "SWELLING DIP SECURIGANTH P" and "SWELLING DIP SECURIGANTH SBU" manufactured by Atotech Japan K.K. The swelling treatment with the swelling liquid is not particularly limited. However, the swelling treatment can be performed by, for example, immersing the insulation layer in the swelling liquid at 30°C to 90°C for 1 minute to 20 minutes. From the viewpoint of restraining swelling of the resin in the insulation layer to an appropriate level, it is preferable to immerse the insulation layer in the swelling liquid at 40°C to 80°C for 5 minutes to 15 minutes.

The oxidizing agent used in the roughening treatment is not particularly limited. However, examples of the oxidizing agent may include an alkaline permanganate solution in which potassium permanganate or sodium permanganate is dissolved in an aqueous solution of sodium hydroxide. The roughening treatment with the oxidizing agent such as the alkaline permanganate solution is preferably performed by immersing the insulation layer in the oxidizing agent solution heated to 60°C to 100°C for 10 minutes to 30 minutes. Furthermore, a concentration of the permanganate in the alkaline permanganate solution is preferably 5% by mass to 10% by mass. Examples of a commercially available oxidizing agent may include an alkaline permanganate solution such as "CONCENTRATE COMPACT CP" or "DOSING SOLUTION SECURIGANS P" manufactured by Atotech.

Furthermore, the neutralizing liquid used for the roughening treatment is preferably an acidic aqueous solution. Examples of a commercially available neutralizing liquid may include "REDUCTION SOLUTION SECURIGANTH P" manufactured by Atotech.

The treatment with the neutralizing liquid can be performed by immersing the treated surface, which has been subjected to the roughening treatment with the oxidizing agent, in the neutralizing liquid at 30°C to 80°C for 5 minutes to 30 minutes. From the viewpoint of workability and the like, a method of immersing the object, which has been subjected to the roughening treatment with the oxidizing agent, in the neutralizing liquid at 40°C to 70°C for 5 minutes to 20 minutes is preferable.

The step (V) is a step of forming a conductive layer, whereby the conductive layer is formed on the insulation layer. A conductor material used for the conductive layer is not particularly limited. In a preferred embodiment, the conductive layer includes one or more types of metal selected from the group consisting of gold, platinum, palladium, silver, copper, aluminum, cobalt, chromium, zinc, nickel, titanium, tungsten, iron, tin, and indium. The conductive layer may be a single metal layer or an alloy layer. Examples of the alloy layer may include a layer formed of an alloy of two or more different metal selected from the above-mentioned group (e.g., a nickel-chromium alloy, a copper-nickel alloy, and a copper-titanium alloy). Of these, from the viewpoint of versatility and costs for forming the conductive layer, easiness of patterning, and the like, a single metal layer of chromium, nickel, titanium, aluminum, zinc, gold, palladium, silver, or copper, or an alloy layer of a nickel-chromium alloy, a copper-nickel alloy, or a copper-titanium alloy is preferable. A single metal layer of chromium, nickel, titanium, aluminum, zinc, gold, palladium, silver, or copper, or an alloy layer of a nickel-chromium alloy is more preferable, and a single metal layer of copper is still more preferable.

The conductive layer may have a single layer structure or a multi-layer structure in which two or more single metal layers or alloy layers formed of different types of metal or alloys are laminated. In a case where the conductive layer has the multilayer structure, a layer in contact with the insulation layer is preferably a single metal layer of chromium, zinc, or titanium, or an alloy layer of a nickel-chromium alloy.

The thickness of the conductive layer is generally 3 µm to 35 µm, preferably 5 µm to 30 µm, depending on a desired design of the printed wiring board.

In an embodiment, the conductive layer may be formed by plating. For example, the conductive layer having a desired wiring pattern can be formed by plating the surface of the insulation layer by a conventionally known technique such as a semi-additive method or a full-additive method. From the viewpoint of simplicity in the production, the conductive layer is preferably formed by the semi-additive method. An example of forming the conductive layer by the semi-additive method will be described below.

First, a plating seed layer is formed on the surface of the insulation layer by electroless plating. Next, a mask pattern is formed on the plating seed layer thus formed to expose a part of the plating seed layer corresponding to a desired wiring pattern. After a metal layer is formed on the exposed plating seed layer by electroplating, the mask pattern is removed. Subsequently, the unnecessary plating seed layer is removed by etching or the like to form the conductive layer having a desired wiring pattern.

In another embodiment, the conductive layer may be formed using a metal foil. In a case where the metal foil is used to form the conductive layer, the step (V) is performed preferably between the step (I) and the step (II). For example, after the step (I), the support is removed, and then the metal foil is laminated on the exposed surface of the resin composition layer. Lamination of the resin composition layer and the metal foil may be performed by a vacuum lamination method. A lamination condition may be the same as the condition described for the step (I). Next, the step (II) is performed to form the insulation layer. Subsequently, the conductive layer having a desired wiring pattern can be formed using the metal foil on the insulation layer by a conventional known technique such as a subtractive method or a modified semi-additive method.

The metal foil can be produced by a known method such as, for example, an electrolysis method or a rolling method. Examples of a commercially available metal foil may include HLP foil and JXUT-III foil manufactured by JX Nippon Mining & Metals Corp. and 3EC-III foil and TP-III foil manufactured by Mitsui Mining & Smelting Co., Ltd.

Alternatively, as described above, in the case where the metal foil or the metal foil with supporting substrate is used as the support for the resin sheet, the conductive layer may be formed using the metal foil.

### [Semiconductor chip package]

The semiconductor chip package of the present invention includes a sealing layer formed of the cured product of the resin composition of the present invention. As described above, the semiconductor chip package of the present invention may also include an insulation layer for forming a redistribution layer (redistribution forming layer), which is formed of the cured product of the resin composition of the present invention.

The semiconductor chip package can be produced, for example, using the resin composition or the resin sheet of the present invention by a method including the following steps (1) to (6). The resin composition or the resin sheet of the present invention may be used to form a sealing layer in the step (3) or a redistribution forming layer in the step (5). An example of forming the sealing layer and the redistribution forming layer using the resin composition or the resin sheet will be described below. However, a technique for forming the sealing layer and the redistribution forming layer of the semiconductor chip packages is known, and those skilled in the art can produce the semiconductor package according to the known technique using the resin composition or the resin sheet of the present invention:
(1) a step of laminating a temporary fixing film on a substrate;
(2) a step of temporarily fixing a semiconductor chip on the temporary fixing film;
(3) a step of forming a sealing layer on the semiconductor chip;
(4) a step of peeling off the substrate and the temporary fixing film from the semiconductor chip;
(5) a step of forming a redistribution forming layer as an insulation layer on the surface of the semiconductor chip from which the substrate and the temporary fixing film have been peeled off; and
(6) a step of forming a redistribution layer as a conductive layer on the redistribution forming layer

### -Step (1)-

A material used for the substrate is not particularly limited. Examples of the substrate may include: a silicon wafer; a glass wafer; a glass substrate; a metal substrate such as copper, titanium, stainless steel, and steel plate cold commercial (SPCC); a substrate prepared by impregnating a glass fiber with an epoxy resin or the like, followed by a thermal curing treatment (e.g., FR-4 substrate); and a substrate made of a bismaleimide triazine resin (BT resin).

A material of the temporary fixing film is not particularly limited as long as the temporary fixing film can temporarily fix the semiconductor chip and can be peeled off from the semiconductor chip in the step (4). A commercially available product can be used as the temporary fixing film. Examples of the commercially available product thereof may include REVALPHA manufactured by Nitto Denko Corp.

### -Step (2)-

The temporal fixing of the semiconductor chip can be performed using a known device such as a flip chip bonder or a die bonder. Arrangement layout and the installation number of the semiconductor chips can be appropriately determined according to the shape and size of the temporary fixing film, the production number of the semiconductor packages of interest, and the like. For example, the semiconductor chips can be arranged in a matrix form of multiple rows and multiple columns and temporarily fixed.

### -Step (3)-

The resin composition layer of the resin sheet of the present invention is laminated on the semiconductor chip, or the resin composition of the present invention is applied onto the semiconductor chip and then cured (e.g., thermally cured), to form a sealing layer.

For example, the lamination of the semiconductor chip and the resin sheet can be performed by removing the protective film from the resin sheet and performing thermocompression bonding of the resin sheet to the semiconductor chip from the support side. Examples of a member for performing the thermocompression bonding of the resin sheet to the semiconductor chip (hereinafter also referred to as "thermocompression bonding member") may include a heated metal plate (a SUS head plate, etc.) and a heated metal roll (a SUS roll). Further, it is preferable that, instead of directly pressing the thermocompression member onto the resin sheet, the thermocompression member is pressed onto the resin sheet through an elastic material such as heat-resistant rubber so that the resin sheet sufficiently follows the uneven surface of the semiconductor chip. The lamination of the semiconductor chip and the resin sheet may be performed by a vacuum lamination method, and a condition for the lamination is the same as the lamination condition described in relation to the method for producing the printed wiring board. Preferable ranges thereof are also the same.

After the lamination, the resin composition is thermally cured to form a sealing layer. A thermal curing condition is the same as the thermal curing condition described in relation to the method for producing the printed wiring board.

The support of the resin sheet may be peeled off after the resin sheet is laminated onto the semiconductor chip and thermally cured, or the support may be peeled off before the resin sheet is laminated onto the semiconductor chip.

In a case where the resin composition of the present invention is applied to form a sealing layer, a condition for the application is the same as the application condition for forming the resin composition layer described in relation to the resin sheet of the present invention. Preferable ranges thereof are also the same.

### -Step (4)-

A method for peeling off the substrate and the temporary fixing film can be appropriately changed according to the material of the temporary fixing film and the like. Example of the method may include a method in which the temporary fixing film is peeled off by heating and foaming (or expanding) the temporary fixing film and a method in which the temporary fixing film is peeled off by irradiating the film with ultraviolet rays from the substrate side and thereby reducing the adhesive force of the temporary fixing film.

In the method in which the temporary fixing film is peeled off by heating and foaming (or expanding) the temporary fixing film, a heating condition is usually 100 to 250°C for 1 to 90 seconds or 5 to 15 minutes. Furthermore, in the method in which the temporary fixing film is peeled off by irradiating the film with ultraviolet rays from the substrate side and thereby reducing the adhesive force of the temporary fixing film, an irradiation dose of ultraviolet rays is usually 10 mJ/cm² to 1000 mJ/cm².

### -Step (5)-

A material for forming the redistribution forming layer (insulation layer) is not particularly limited as long as insulation properties are exhibited when the redistribution forming layer (insulation layer) is formed. From the viewpoint of easiness in the production of the semiconductor chip package, a photosensitive resin or a thermosetting resin is preferable. The redistribution forming layer may be formed using the resin composition or the resin sheet of the present invention.

After the redistribution forming layer is formed, a via hole may be formed in the redistribution forming layer for interlayer connection between the semiconductor chip and a conductive layer described below. The via hole may be formed by a known method depending on the material of the rewiring forming layer.

### -Step (6)-

The formation of the conductive layer on the redistribution forming layer may be performed in the same manner as the step (V) described in relation to the method for producing the printed wiring board. Note that the step (5) and the step (6) may be repeated to alternately laminate (build up) the conductive layers (redistribution layers) and the redistribution forming layers (insulation layers).

In the production of the semiconductor chip package, a step (7) of forming a solder resist layer on the conductive layer (redistribution layer), a step (8) of forming a bump, and a step (9) of dicing a plurality of semiconductor chip packages into individual semiconductor chip packages, thereby separating them as individual pieces, may be further performed. These steps may be performed according to various methods known to those skilled in the art used in the production of the semiconductor chip package.

When the sealing layer and the redistribution forming layer are formed by using the resin composition or the resin sheet of the present invention that achieves a cured product exhibiting excellent dielectric properties and favorable chemical resistance, regardless of whether the semiconductor package is a fan-in type package or a fan-out type package, it is possible to achieve the semiconductor chip package with extremely low transmission loss while suppressing the occurrence of a crack defect or an interfacial delamination defect. In an embodiment, the semiconductor chip package of the present invention is a fan-out type package. The resin composition or the resin sheet of the present invention can be applied for both fan-out panel level packaging (FOPLP) and fan-out wafer level packaging (FOWLP). In an embodiment, the semiconductor package of the present invention is a product of the fan-out panel level packaging (FOPLP). In another embodiment, the semiconductor package of the present invention is a product of the fan-out wafer level packaging (FOWLP).

### [Semiconductor device]

A semiconductor device of the present invention includes a layer formed of the cured product of the resin composition layer of the present invention. The semiconductor device of the present invention can be produced by using the printed wiring board or the semiconductor chip package of the present invention.

Examples of the semiconductor device may include various semiconductor devices used in electrical products (e.g., a computer, a mobile phone, a digital camera, a television, etc.) and vehicles (e.g., a motorcycle, an automobile, a train, a ship, an aircraft, etc.).

### Examples

### <Example 1> Synthesis of polyester resin (1)

### (1) Synthesis of raw material hydroxy compound (1)

In a 2-liter four-neck round flask equipped with a stirrer, a thermometer, a dropping funnel and a nitrogen gas inlet, 99.0 g of a dicyclopentadiene-phenol polyaddition product ("J-DPP85" manufactured by JFE Chemical Corp., hydroxyl equivalent of 165 g/eq.) and 26.4 g of ethylene carbonate (reagent) were charged. The mixture was stirred while nitrogen gas was blown, and heated up to 100°C to be completely dissolved. To the mixture, 2.6 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 300 g of methyl isobutyl ketone was added to completely dissolve the contents in the mixture. To the resulting mixture, 70 g of distilled water and 7.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 94 g of a desired raw material hydroxy compound (1). The hydroxyl equivalent of this compound was 185 g/eq. (the theoretical value of 187 g/eq.; corresponding to x1 + x2 = 1), confirming that the compound had the desired molecular structure.

### (2) Esterification reaction -synthesis of polyester resin (1)-

In a 0.5-liter four-neck round flask equipped with a stirrer, a thermometer, a dropping funnel and a nitrogen gas inlet, 37.4 g of the hydroxy compound (1) obtained in the above-described (1), 14.4 g of 1-naphthol, 30.5 g of isophthalic chloride, 0.41 g of a phase transfer catalyst, and 190 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 67 g of a desired polyester resin (1).

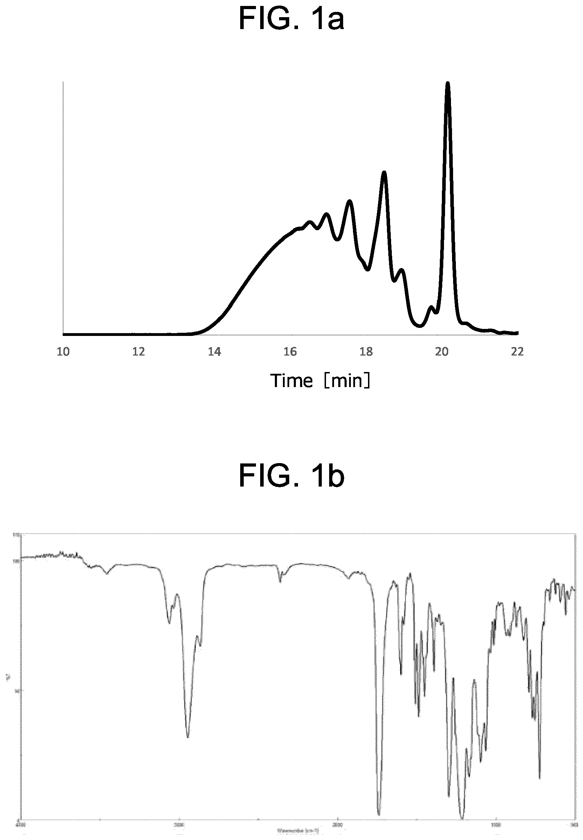

The polyester resin (1) thus obtained was measured by a gel permeation chromatography (GPC) method and an infrared spectroscopy (IR) method under the following GPC measurement condition and IR measurement condition. The polyester resin (1) had the number-average molecular weight of 872 by GPC and Tg of 65°C by the DSC measurement. A GPC chart of the polyester resin (1) is shown in FIG. 1a, and an IR chart is shown in FIG. 1b. Furthermore, in the mass spectra, a spectrum of m/z = 868 corresponding to x1 = x2 = 0, a spectrum of m/z = 912 corresponding to x1 + x2 = 1, and a spectrum of m/z = 956 corresponding to x1 + x2 = 2, were each observed as expected in the component with N = 1 in the theoretical structure of the desired substance. The result confirmed that the obtained polyester resin (1) had the desired molecular structure.

### (GPC measurement condition)

Measurement device: "HLC-8420GPC" manufactured by Tosoh Corp.
Column: Guard Column "HXL-L" manufactured by Tosoh Corp. + "TSKgel SuperHZ2000" manufactured by Tosoh Corp. + "TSKgel SuperHZ2000" manufactured by Tosoh Corp. + "TSKgel SuperHZ3000" manufactured by Tosoh Corp. + "TSKgel SuperHZ4000" manufactured by Tosoh Corp.
Detector: RI (differential refractometer)
Data processing: "GPC Workstation EcoSEC-WorkStation" manufactured by Tosoh Corp.
Column temperature: 40°C
Developing solvent: tetrahydrofuran
Flow rate: 0.35 ml/min
Standard: the following monodisperse polystyrene with known molecular weight was used in accordance with the measurement manual of "GPC Workstation EcoSEC-WorkStation" described above.
   TSKgel F-10, F-4, F-1, A-5000, A-1000, A-500 (manufactured by Tosoh Corp.)
Sample: microfiltered tetrahydrofuran solution with resin solid content of 0.2% by mass (10 µl)

### (IR measurement condition)

Measurement device: "FT/IR-4600" manufactured by JASCO Corp.

### <Example 2> Synthesis of polyester resin (2)

### (1) Synthesis of raw material hydroxy compound (2)

In a 2-liter four-neck round flask equipped with a stirrer, a thermometer, a dropping funnel and a nitrogen gas inlet, 99.0 g of a dicyclopentadiene-phenol polyaddition product ("J-DPP85" manufactured by JFE Chemical Corp., hydroxyl equivalent of 165 g/eq.) and 30.6 g of propylene carbonate (reagent) were charged. The mixture was stirred while nitrogen gas was blown, and heated up to 100°C to be completely dissolved. To the mixture, 2.7 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 300 g of methyl isobutyl ketone was added to completely dissolve the contents in the mixture. To the resulting mixture, 70 g of distilled water and 7.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 96 g of a desired raw material hydroxy compound (2). The hydroxyl equivalent of this compound was 192 g/eq. (the theoretical value of 194 g/eq.; corresponding to x1 + x2 = 1), confirming that the compound had the desired molecular structure.

### (2) Esterification reaction -synthesis of polyester resin (2)-

In a 0.5-liter four-neck round flask equipped with a stirrer, a thermometer, a dropping funnel and a nitrogen gas inlet, 38.8 g of the hydroxy compound (2) obtained in the above-described (1), 14.4 g of 1-naphthol, 30.5 g of isophthalic chloride, 0.42 g of a phase transfer catalyst, and 190 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 67 g of a desired polyester resin (2).

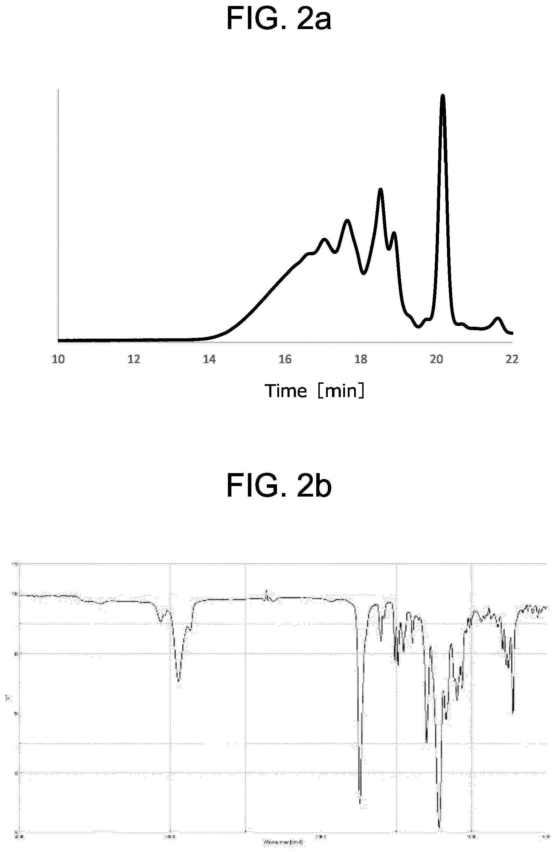

The polyester resin (2) thus obtained was measured by GPC and IR by the same manner as that in Example 1. The polyester resin (2) had the number-average molecular weight of 825 by GPC and Tg of 50°C by the DSC measurement. A GPC chart of the polyester resin (2) is shown in FIG. 2a, and an IR chart is shown in FIG. 2b. Furthermore, in the mass spectra, a spectrum of m/z = 868 corresponding to x1 = x2 = 0, a spectrum of m/z = 926 corresponding to x1 + x2 = 1, and a spectrum of m/z = 984 corresponding to x1 + x2 = 2, were each observed as expected in the component with N = 1 in the theoretical structure of the desired substance. The result confirmed that the obtained polyester resin (2) had the desired molecular structure.

### <Example 3> Synthesis of polyester resin (3)

A desired polyester resin (3) in an amount of 62 g was obtained by the same manner as that in Example 2, except that 9.4 g of phenol was used instead of 14.4 g of 1-naphthol in the esterification reaction.

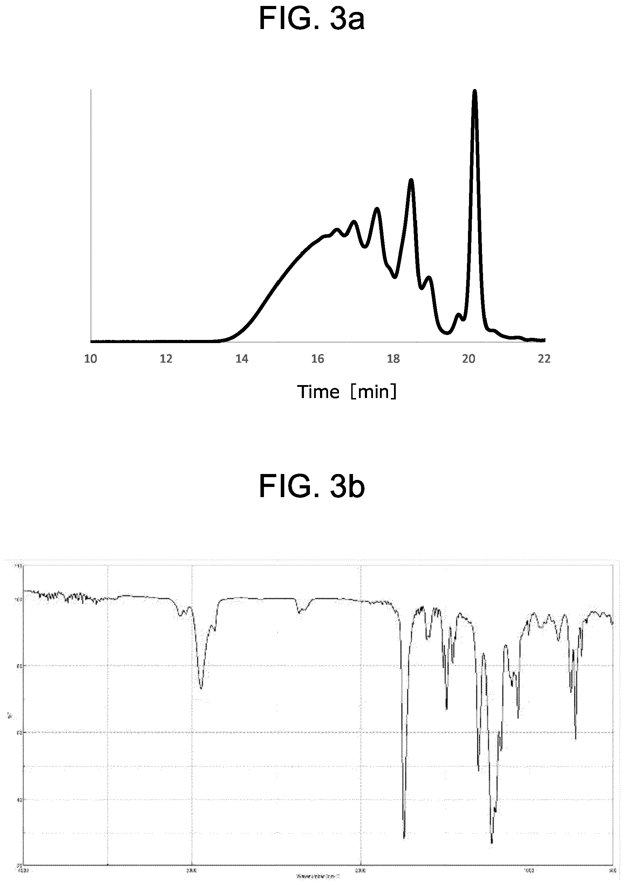

The polyester resin (3) thus obtained was measured by GPC and IR by the same manner as that in Example 1. The polyester resin (3) had the number-average molecular weight of 895 by GPC and Tg of 49°C by the DSC measurement. A GPC chart of the polyester resin (3) is shown in FIG. 3a, and an IR chart is shown in FIG. 3b. Furthermore, in the mass spectra, a spectrum of m/z = 768 corresponding to x1 = x2 = 0, a spectrum of m/z = 826 corresponding to x1 + x2 = 1, and a spectrum of m/z = 884 corresponding to x1 + x2 = 2, were each observed as expected in the component with N = 1 in the theoretical structure of the desired substance. The result confirmed that the obtained polyester resin (3) had the desired molecular structure.

### <Example 4> Synthesis of polyester resin (4)

### (1) Synthesis of raw material hydroxy compound (4)

In a 2-liter four-neck round flask equipped with a stirrer, a thermometer, a dropping funnel and a nitrogen gas inlet, 80.0 g of a bisphenol F ("Bis-F" manufactured by Honshu Chemical Industry Co., Ltd., hydroxyl equivalent of 100 g/eq.) and 49.3 g of ethylene carbonate (reagent) were charged. The mixture was stirred while nitrogen gas was blown, and heated up to 100°C to be completely dissolved. To the mixture, 3.7 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 200 g of methyl isobutyl ketone was added to completely dissolve the contents in the mixture. To the resulting mixture, 70 g of distilled water and 7.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 110 g of a desired raw material hydroxy compound (4). The hydroxyl equivalent of this compound was 132 g/eq. (the theoretical value of 131 g/eq.; corresponding to x1 + x2 = 1.4), confirming that the compound had the desired molecular structure.

### (2) Esterification reaction -synthesis of polyester resin (4)-

In a 0.5-liter four-neck round flask equipped with a stirrer, a thermometer, a dropping funnel and a nitrogen gas inlet, 26.2 g of the hydroxy compound (4) obtained in the above-described (1), 9.4 g of phenol, 30.5 g of isophthalic chloride, 0.33 g of a phase transfer catalyst, and 150 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 48 g of a desired polyester resin (4).

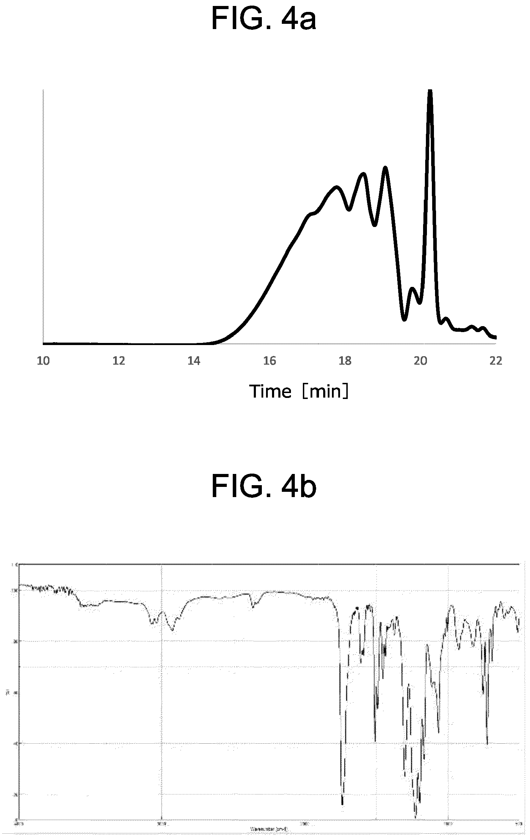

The polyester resin (4) thus obtained was measured by GPC and IR by the same manner as that in Example 1. The polyester resin (4) had the number-average molecular weight of 680 by GPC and Tg of 45°C by the DSC measurement. A GPC chart of the polyester resin (4) is shown in FIG. 4a, and an IR chart is shown in FIG. 4b. Furthermore, in the mass spectra, a spectrum of m/z = 648 corresponding to x1 = x2 = 0, a spectrum of m/z = 692 corresponding to x1 + x2 = 1, and a spectrum of m/z = 736 corresponding to x1 + x2 = 2, were each observed as expected in the component with N = 1 in the theoretical structure of the desired substance. The result confirmed that the obtained polyester resin (4) had the desired molecular structure.

### <Example 5> Synthesis of polyester resin (5)

### (1) Synthesis of raw material hydroxy compound (5)

In a 2-liter four-neck round flask equipped with a stirrer, a thermometer, a dropping funnel and a nitrogen gas inlet, 80.0 g of a bisphenol F ("Bis-F" manufactured by Honshu Chemical Industry Co., Ltd., hydroxyl equivalent of 100 g/eq.) and 40.8 g of propylene carbonate (reagent) were charged. The mixture was stirred while nitrogen gas was blown, and heated up to 100°C to be completely dissolved. To the mixture, 2.5 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 200 g of methyl isobutyl ketone was added to completely dissolve the contents in the mixture. To the resulting mixture, 70 g of distilled water and 7.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 87 g of a desired raw material hydroxy compound (5). The hydroxyl equivalent of this compound was 131 g/eq. (the theoretical value of 129 g/eq.; corresponding to x1 + x2 = 1), confirming that the compound had the desired molecular structure.

### (2) Esterification reaction -synthesis of polyester resin (5)-

In a 2-liter four-neck round flask equipped with a stirrer, a thermometer, a dropping funnel and a nitrogen gas inlet, 25.8 g of the hydroxy compound (5) obtained in the above-described (1), 14.4 g of 1-naphthol, 30.5 g of isophthalic chloride, 0.37 g of a phase transfer catalyst, and 170 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 51 g of a desired polyester resin (5).

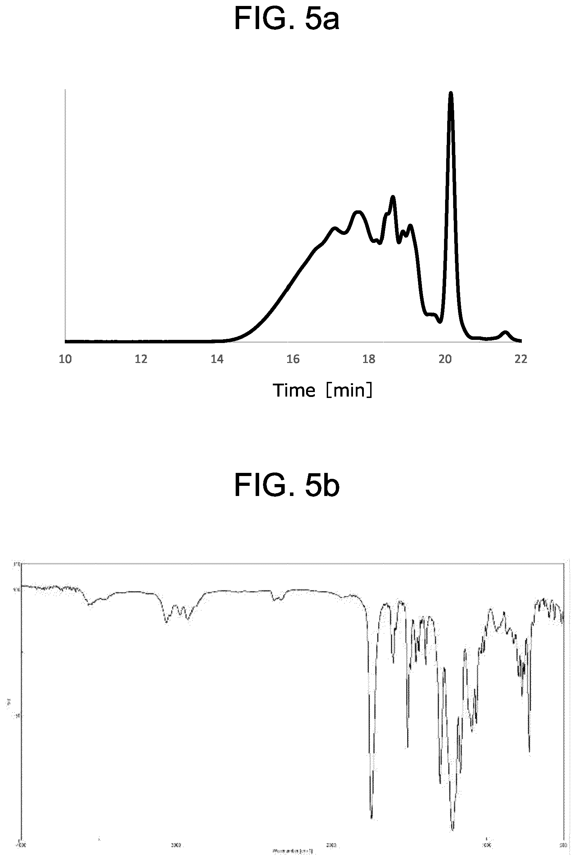

The polyester resin (5) thus obtained was measured by GPC and IR by the same manner as that in Example 1. The polyester resin (5) had the number-average molecular weight of 722 by GPC and Tg of 51°C by the DSC measurement. A GPC chart of the polyester resin (5) is shown in FIG. 5a, and an IR chart is shown in FIG. 5b. Furthermore, in the mass spectra, a spectrum of m/z = 748 corresponding to x1 = x2 = 0, a spectrum of m/z = 806 corresponding to x1 + x2 = 1, and a spectrum of m/z = 864 corresponding to x1 + x2 = 2, were each observed as expected in the component with N = 1 in the theoretical structure of the desired substance. The result confirmed that the obtained polyester resin (5) had the desired molecular structure.

### <Example 6> Synthesis of polyester resin (6)

A desired polyester resin (6) in an amount of 62 g was obtained by the same manner as that in Example 1, except that terephthalic chloride was used instead of isophthalic chloride in the esterification reaction.

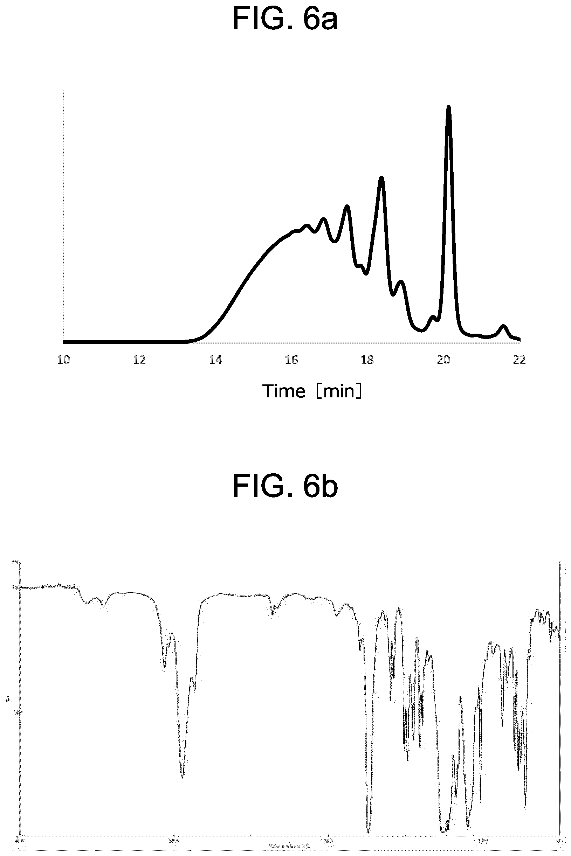

The polyester resin (6) thus obtained was measured by GPC and IR by the same manner as that in Example 1. The polyester resin (6) had the number-average molecular weight of 928 by GPC and Tg of 67°C by the DSC measurement. A GPC chart of the polyester resin (6) is shown in FIG. 6a, and an IR chart is shown in FIG. 6b. Furthermore, in the mass spectra, a spectrum of m/z = 868 corresponding to x1 = x2 = 0, a spectrum of m/z = 912 corresponding to x1 + x2 = 1, and a spectrum of m/z = 956 corresponding to x1 + x2 = 2, were each observed as expected in the component with N = 1 in the theoretical structure of the desired substance. The result confirmed that the obtained polyester resin (6) had the desired molecular structure.

### <Example 7> Synthesis of polyester resin (7)

### (1) Synthesis of raw material hydroxy compound (7)

In a 2-liter four-neck round flask equipped with a stirrer, a thermometer, a dropping funnel and a nitrogen gas inlet, 70.0 g of bisphenol fluorene ("BPF" manufactured by Osaka Gas Chemicals Co., Ltd., hydroxyl equivalent of 175 g/eq.) and 17.6 g of ethylene carbonate (reagent) were charged. The mixture was stirred while nitrogen gas was blown, and heated up to 150°C to be completely dissolved. To the mixture, 1.8 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 200 g of methyl isobutyl ketone was added to completely dissolve the contents in the mixture. To the resulting mixture, 70 g of distilled water and 7.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 70 g of a desired raw material hydroxy compound (7). The hydroxyl equivalent of this compound was 195 g/eq. (the theoretical value of 197 g/eq.; corresponding to x1 + x2 = 1), confirming that the compound had the desired molecular structure.

### (2) Esterification reaction -synthesis of polyester resin (7)-

In a 0.5-liter four-neck round flask equipped with a stirrer, a thermometer, a dropping funnel and a nitrogen gas inlet, 39.4 g of the hydroxy compound (7) obtained in the above-described (1), 14.4 g of 1-naphthol, 30.5 g of isophthalic chloride, 0.43 g of a phase transfer catalyst, and 195 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 65 g of a desired polyester resin (7).

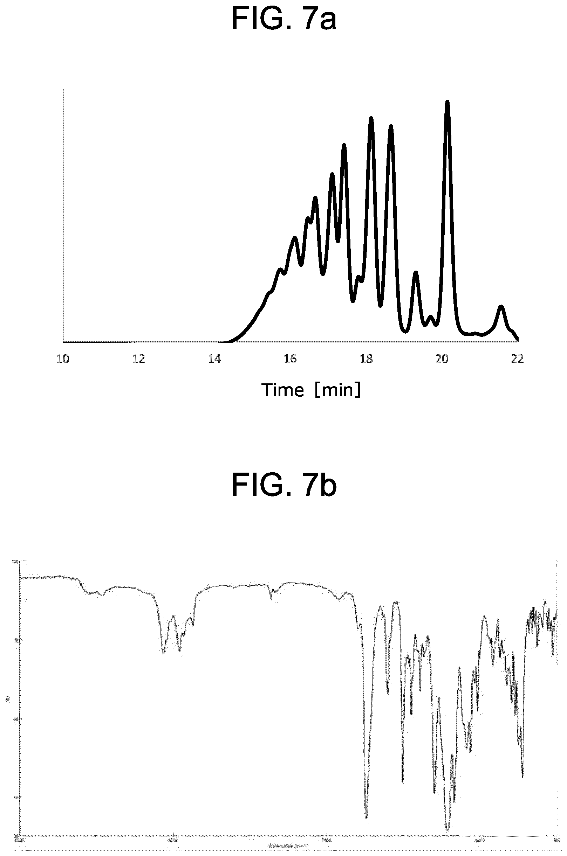

The polyester resin (7) thus obtained was measured by GPC and IR by the same manner as that in Example 1. The polyester resin (7) had the number-average molecular weight of 803 by GPC and Tg of 75°C by the DSC measurement. A GPC chart of the polyester resin (7) is shown in FIG. 7a, and an IR chart is shown in FIG. 7b. Furthermore, in the mass spectra, a spectrum of m/z = 898 corresponding to x1 = x2 = 0, a spectrum of m/z = 942 corresponding to x1 + x2 = 1, and a spectrum of m/z = 986 corresponding to x1 + x2 = 2, were each observed as expected in the component with N = 1 in the theoretical structure of the desired substance. The result confirmed that the obtained polyester resin (7) had the desired molecular structure.

### <Example 8> Synthesis of polyester resin (8)

### (1) Synthesis of raw material hydroxy compound (8)

In a 2-liter four-neck round flask equipped with a stirrer, a thermometer, a dropping funnel and a nitrogen gas inlet, 100.8 g of 2,2-bis(4-hydroxyphenyl)hexafluoropropane (bisphenol AF, hydroxyl equivalent of 168 g/eq.) and 15.8 g of ethylene carbonate (reagent) were charged. The mixture was stirred while nitrogen gas was blown, and heated up to 100°C to be completely dissolved. To the mixture, 2.4 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 200 g of methyl isobutyl ketone was added to completely dissolve the contents in the mixture. To the resulting mixture, 70 g of distilled water and 10.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 95 g of a desired raw material hydroxy compound (8). The hydroxyl equivalent of this compound was 177 g/eq. (the theoretical value of 175 g/eq.; corresponding to x1 + x2 = 0.6), confirming that the compound had the desired molecular structure.

### (2) Esterification reaction -synthesis of polyester resin (8)-

In a 0.5-liter four-neck round flask equipped with a stirrer, a thermometer, a dropping funnel and a nitrogen gas inlet, 34.9 g of the hydroxy compound (8) obtained in the above-described (1), 18.4 g of pentafluoro phenol, 30.5 g of isophthalic chloride, 0.42 g of a phase transfer catalyst, and 180 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 62 g of a desired polyester resin (8).

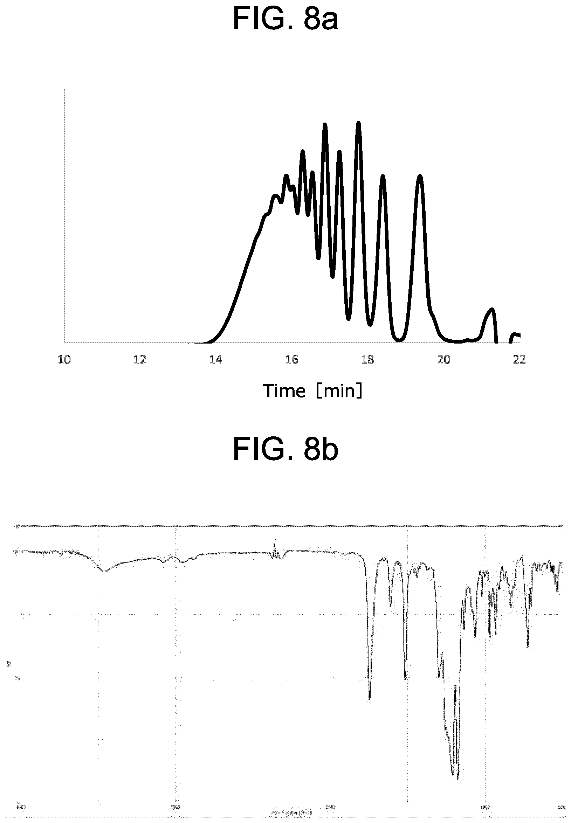

The polyester resin (8) thus obtained was measured by GPC and IR by the same manner as that in Example 1. The polyester resin (8) had the number-average molecular weight of 1293 by GPC and Tg of 46°C by the DSC measurement. A GPC chart of the polyester resin (8) is shown in FIG. 8a, and an IR chart is shown in FIG. 8b. Furthermore, in the mass spectra, a spectrum of m/z = 964 corresponding to x1 = x2 = 0, a spectrum of m/z = 1008 corresponding to x1 + x2 = 1, and a spectrum of m/z = 1052 corresponding to x1 + x2 = 2, were each observed as expected in the component with N = 1 in the theoretical structure of the desired substance. The result confirmed that the obtained polyester resin (8) had the desired molecular structure.

### <Example 9> Synthesis of polyester resin (9)

### (1) Synthesis of benzyl-modified 2,7-dihydroxynaphthalene

In a 2-liter four-neck round flask equipped with a stirrer, a thermometer, a nitrogen gas inlet and a Dean-Stark receiver, 64.0 g of 2,7-dihydroxynaphthalene (manufactured by Tokyo Chemical Industry Co., Ltd.), 86.4 g of benzyl alcohol (manufactured by Junsei Chemical Co., Ltd.), and 1.50 g of 4-toluenesulfonic acid monohydrate (manufactured by Junsei Chemical Co., Ltd.) were charged, and the mixture was stirred while nitrogen gas was blown and heated up to 160°C. During this procedure, foaming by dehydration and water distillation were observed. After confirming that the foaming had stopped completely, the stirring was further continued for 1 hour at that temperature. Then, 200 g of methyl isobutyl ketone was added to completely dissolve the contents in the mixture. To the resulting mixture, 70 g of distilled water and 0.9 g of a 50% caustic soda aqueous solution were added for neutralization, followed by washing three times with the same amount of distilled water. Then, after azeotropic dehydration and microfiltration were performed in this order, finally, distillation under reduced pressure was performed at 180°C to obtain 130 g of a desired benzyl-modified dihydroxynaphthalene (1). The hydroxyl equivalent of this compound was 168 g/eq. (theoretical value of 170 g/eq.), confirming that the compound had the desired molecular structure.

### (2) Synthesis of raw material hydroxy compound (9)

In a 2-liter four-neck round flask equipped with a stirrer, a thermometer, a dropping funnel and a nitrogen gas inlet, 102.0 g of the benzyl-modified dihydroxynaphthalene synthesized in the above (1) and 26.4 g of ethylene carbonate (reagent) were charged, and the mixture was stirred while nitrogen gas was blown and heated up to 100°C to be completely dissolved. To the mixture, 2.6 g of a 48% KOH aqueous solution was added, and the resulting mixture was heated up to 180°C while being stirred. The resin solution intensely foamed due to carbon dioxide gas generated during this procedure. After confirming that the foaming had completely stopped, the stirring was further continued for 1 hour at that temperature. Then, 300 g of methyl isobutyl ketone was added to completely dissolve the contents in the mixture. To the resulting mixture, 70 g of distilled water and 7.0 g of disodium hydrogen phosphate were added for neutralization, followed by washing three times with the same amount of distilled water. Then, after azeotropic dehydration and microfiltration were performed in this order, finally, distillation under reduced pressure was performed at 180°C to obtain 96 g of a desired raw material hydroxy compound (9). The hydroxyl equivalent of this compound was 190 g/eq. (the theoretical value of 192 g/eq.; corresponding to x1 + x2 = 1), confirming that the compound had the desired molecular structure.

### (3) Esterification reaction -synthesis of polyester resin (9)-

In a 0.5-liter four-neck round flask equipped with a stirrer, a thermometer, a dropping funnel and a nitrogen gas inlet, 38.4 g of the hydroxy compound (9) obtained in the above (2), 14.4 g of 1-naphthol, 30.5 g of isophthalic chloride, 0.41 g of a phase transfer catalyst, and 170 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture to completely dissolve by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 65 g of a desired polyester resin (9).

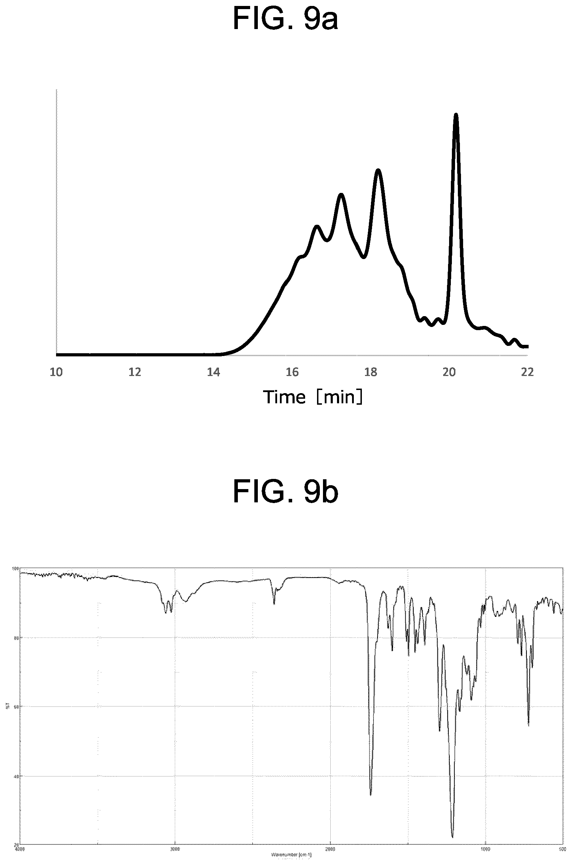

The polyester resin (9) thus obtained was measured by GPC and IR in the same manner as in Example 1. The polyester resin (9) had the number-average molecular weight of 872 by GPC and Tg of 65°C by the DSC measurement. A GPC chart of the polyester resin (9) is shown in FIG. 9a, and an IR chart is shown in FIG. 9b. Furthermore, in the mass spectra, a spectrum of m/z = 888 corresponding to x1 = x2 = 0, a spectrum of m/z = 932 corresponding to x1 + x2 = 1, and a spectrum of m/z = 976 corresponding to x1 + x2 = 2, were each observed as expected in the component with N = 1 in the theoretical structure of the desired substance. The result confirmed that the obtained polyester resin (9) had the desired molecular structure.

### <Comparative Example 1> Synthesis of polyester resin (10)

In a 0.5-liter four-neck round flask equipped with a stirrer, a thermometer, a dropping funnel and a nitrogen gas inlet, 33 g of a dicyclopentadiene-phenol polyaddition product ("J-DPP85" manufactured by JFE Chemical Corp., hydroxyl equivalent of 165 g/eq.), 14.4 g of 1-naphthol, 30.5 g of isophthalic chloride, 0.39 g of a phase transfer catalyst, and 130 g of methyl isobutyl ketone were charged, and the mixture was stirred while nitrogen gas was blown to be completely dissolved. To this mixture, 60.0 g of a 20% caustic soda aqueous solution was added dropwise for 1 hour at 30°C to a final temperature of 60°C with careful attention to heat generation. Then, after the mixture was further continuously stirred at 60°C for 2 hours, 50 g of distilled water was added to the mixture, thereby completely dissolving by-product inorganic salts. Then, the resulting liquid was transferred to a separatory funnel and subjected to static liquid separation to discard the lower layer (aqueous layer). Furthermore, the remaining liquid was washed with water three times to be completely neutralized and then dehydrated by azeotropic distillation and subjected to microfiltration. The resulting solution was subjected to vacuum distillation at 200°C to remove the solvent, thereby obtaining 56 g of a desired polyester resin (10).

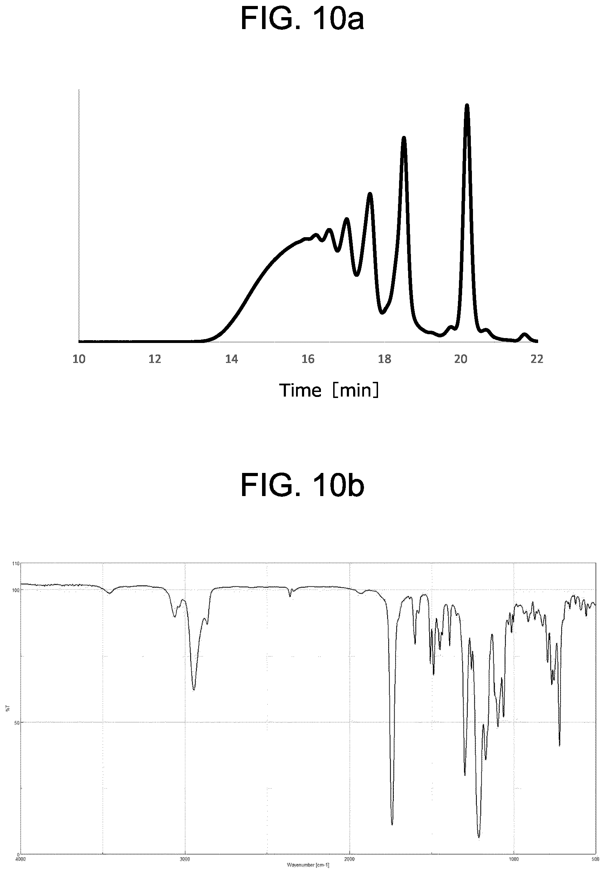

The polyester resin (10) thus obtained was measured by GPC and IR by the same manner as that in Example 1. The polyester resin (10) had the number-average molecular weight of 947 by GPC and Tg of 60°C by the DSC measurement. A GPC chart of the polyester resin (10) is shown in FIG. 10a, and an IR chart is shown in FIG. 10b. Furthermore, in the mass spectra, a spectrum of m/z = 868 corresponding to x1 = x2 = 0 was observed as expected in the component with N = 1 in the theoretical structure of the desired substance.

Regarding the polyester resins (1) to (10) synthesized in Examples 1 to 9 and Comparative Example 1, general formulas related to the theoretical structures thereof are shown, and each structural unit and the like are summarized in Tables 1-1 and 1-2.

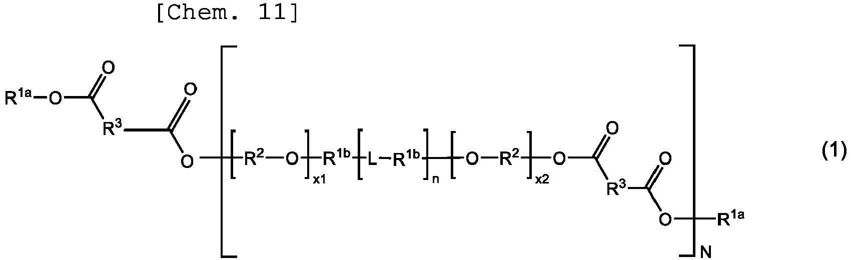

### [Table 1-1]

**(Table 1-1)**

| Polyester resin | R^{1a} | R³ | -R^{1b}-[L-R^{1b}]ₙ- | | R² | x1+x2 | Ratio of skeleton (A) * |
|---|---|---|---|---|---|---|---|
| (1) | 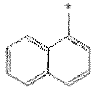 | 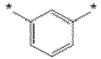 | 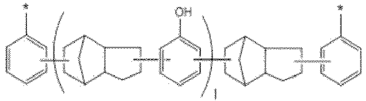 | | 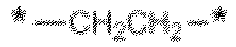 | 1 | 0.67 |
| | | | | (n=1-5 [l=0-4]) | | | |
| (2) | 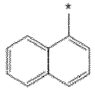 | 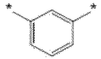 | 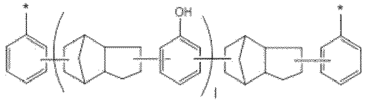 | | 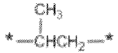 | 1 | 0.67 |
| | | | | (n=1-5 [l=0-4]) | | | |
| (3) | 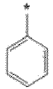 | 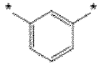 | 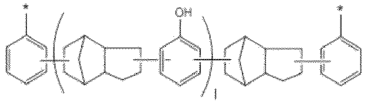 | | 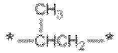 | 1 | 0.67 |
| | | | | (n=1-5 [l=0-4]) | | | |
| (4) | 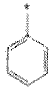 | 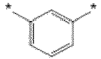 | 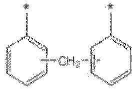 | (n=1) | 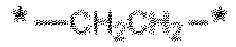 | 1.4 | 0.53 |
| (5) | 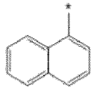 | 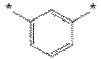 | 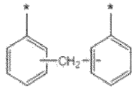 | (n=1) | 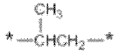 | 1 | 0.67 |

| | | | | | | | |
|---|---|---|---|---|---|---|---|
| * Ratio [(A)/((A)+(B))] of the number of oxycarbonyl groups derived from skeleton (A) relative to the total number of oxycarbonyl groups derived from skeleton (A) and skeleton (B) | | | | | | | |

### [Table 1-2]

**(Table 1-2)**

| Polyester resin | R^{1a} | R³ | -R^{1b}-[L-R^{1b}]ₙ- | | | R² | x1+x2 | Ratio of skeleton (A) * |
|---|---|---|---|---|---|---|---|---|
| (6) | 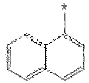 | 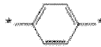 ' | 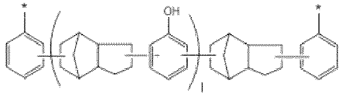 | | | *-CH₂CH₂-* | 1 | 0.67 |
| | | | | (n=1-5 [l=0-4]) | | | | |
| (7) | 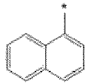 | 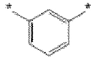 | 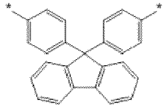 | (n=1) | | *-CH₂CH₂-* | 1 | 0.67 |
| (8) | 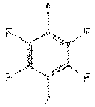 | 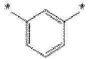 | 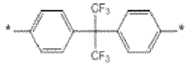 | (n=1) | | *-CH₂CH₂-* | 0.6 | 0.8 |
| (9) | 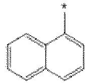 | 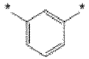 | 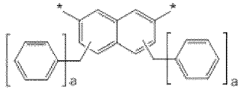 | | (n=0) | *-CH₂CH₂-* | 1 | 0.67 |
| | | | ("a" is each independently about 1) | | | | | |
| (10) | 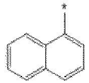 | 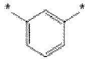 | 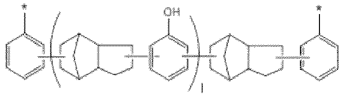 | | | 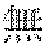 | 0 | 1 |
| | | | (n=1-5 [l=0-4]) | | | | | |

| | | | | | | | | |
|---|---|---|---|---|---|---|---|---|
| * Ratio [(A)/((A)+(B))] of the number of oxycarbonyl groups derived from skeleton (A) relative to the total number of oxycarbonyl groups derived from skeleton (A) and skeleton (B) | | | | | | | | |

### <Examples 10 to 18 and Comparative example 2>

### (1) Preparation of resin composition

Using the synthesized polyester resins (1) to (10), Table 2 below were prepared.

### (2) Production of resin sheet

The resin composition was applied onto a polythylene terephthalate film (thickness of 38 µm, hereinafter abbreviated as a "PET film") with a die coater so that the thickness of the resin composition layer after drying became 40 µm. The resin composition was dried at 120°C for 2 minutes to produce a resin sheet.

### (3) Production of cured product

The resin sheet thus produced was heated at 190°C for 90 minutes to thermally cure the resin composition layer. Next, the PET film was peeled off to obtain a sheet-like cured product.

The cured product was subjected to evaluation tests in the following manner. The result is shown in Table 3.

### [Dielectric properties]

The cured product was cut into a test piece of 2 mm width and 80 mm length, which was used to measure the dielectric constant and dielectric loss tangent with a cavity resonance method at a measurement frequency of 5.8 GHz and 23°C using a cavity resonator perturbation method-based dielectric constant measuring device ("CP521" manufactured by Kanto Electronics Application & Development Inc.) and a network analyzer ("E8362B" manufactured by Agilent Technologies Japan, Ltd.). For each cured product, two test pieces were measured (n = 2) to calculate their average value.

### [Chemical resistance]

### (a) Evaluation of weight change ratio

The cured product was cut into a test piece of 10 mm width and 50 mm length, which was dried in an oven heated to 100°C for 30 minutes and then used for measurement of a weight (M1). Next, the test piece was immersed in a 10% by weight sodium hydroxide aqueous solution and then 10% by weight sulfuric acid, each at 40°C for 24 hours. Subsequently, the immersed test piece was thoroughly washed with water and dried in an oven heated to 100°C for 30 minutes, and its weight (M2) was measured. Based on the measured weights M1 and M2, a weight change ratio (%) (= (M1 - M2)/M1 × 100) after the chemical immersion was calculated.

### (b) Evaluation of strength change ratio

The cured product was cut into a test piece of 10 mm width and 50 mm length, which was dried in an oven heated to 100°C for 30 minutes and then used for measurement of a tensile strength (S1). Note that the tensile strength was measured according to JIS K 7161 with a TENSILON universal testing machine (manufactured by A&D Co., Ltd.) at a temperature of 25°C, a humidity of 60% RH, and a tensile speed of 50 mm/min. Next, the test piece was immersed in a 10% by weight sodium hydroxide aqueous solution and then 10% by weight sulfuric acid, each at 40°C for 24 hours. Subsequently, the immersed test piece was thoroughly washed with water and dried in an oven heated to 100°C for 30 minutes to measure a tensile strength (S2). Based on the measured strengths S1 and S2, a strength change ratio (%) (= (S1 - S2)/S1 × 100) after the chemical immersion was calculated.

### [Table 2]

**(Table 2)**

| | | | Examples | | | | | | | | | Co mparative Example |
|---|---|---|---|---|---|---|---|---|---|---|---|---|
| | | | 10 | 11 | 12 | 13 | 14 | 15 | 16 | 17 | 18 | 2 |
| Blending components (parts by mass) | Polyester resin | (1) | 35 | | | | | | | | | |
| | | (2) | | 35 | | | | | | | | |
| | | (3) | | | 35 | | | | | | | |
| | | (4) | | | | 35 | | | | | | |
| | | (5) | | | | | 35 | | | | | |
| | | (6) | | | | | | 35 | | | | |
| | | (7) | | | | | | | 35 | | | |
| | | (8) | | | | | | | | 35 | | |
| | | (9) | | | | | | | | | 35 | |
| | | (10) | | | | | | | | | | 35 |
| | NC-3000 | | 27 | 27 | 27 | 27 | 27 | 27 | 27 | 27 | 27 | 27 |
| | DMAP | | 0.6 | 0.6 | 0.6 | 0.6 | 0.6 | 0.6 | 0.6 | 0.6 | 0.6 | 0.6 |
| | MEK | | 25 | 25 | 25 | 25 | 25 | 25 | 25 | 25 | 25 | 25 |

| | | | | | | | | | | | | |
|---|---|---|---|---|---|---|---|---|---|---|---|---|
| NC-3000: Biphenyl aralkyl type epoxy resin (manufactured by Nippon Kayaku Co., Ltd) DMAP: 4-dimethylaminopyridine MEK: Methyl ethyl ketone | | | | | | | | | | | | |

### [Table 3]

**(Table 3)**

| | | Dielectric properties | | Chemical resistance | | | |
|---|---|---|---|---|---|---|---|
| | | Dielectric constant | Dielectric loss tangent | Alkali resistance | | Acid resistance | |
| | | | | Weight change ratio (%) | Strength change ratio (%) | Weight change ratio (%) | Strength change ratio (%) |
| Examples | 10 | 2.6 | 0.0064 | 0.1 | 0.1 | 0.1 | 0.2 |
| | 11 | 2.6 | 0.0065 | 0.1 | 0.1 | 0.1 | 0.2 |
| | 12 | 2.8 | 0.0070 | 0.2 | 0.1 | 0.1 | 0.2 |
| | 13 | 2.8 | 0.0069 | 0.2 | 0.1 | 0.2 | 0.3 |
| | 14 | 2.8 | 0.0071 | 0.3 | 0.4 | 0.2 | 0.3 |
| | 15 | 2.6 | 0.0065 | 0.2 | 0.2 | 0.1 | 0.2 |
| | 16 | 2.6 | 0.0063 | 0.1 | 0.1 | 0.1 | 0.1 |
| | 17 | 2.6 | 0.0065 | 0.3 | 0.5 | 0.3 | 0.4 |
| | 18 | 2.6 | 0.0065 | 0.1 | 0.1 | 0.1 | 0.2 |
| Comparative Example | 2 | 2.6 | 0.0068 | 7.8 | 9.0 | 5.5 | 7.1 |

## Claims

1. A polyester resin containing both the following skeleton (A) and skeleton (B):
<Skeleton (A)> a skeleton represented by the formula: (-)R¹-O-C(=O)-R³-, and
<Skeleton (B)> a skeleton represented by the formula: -R²-O-C(=O)-R³-
(in the formulas,
R¹ represents a monovalent or divalent aromatic group,
R² represents a divalent aliphatic group, and
R³ represents a divalent aromatic group).

2. The polyester resin according to claim 1, wherein the polyester resin is blocked at its molecular chain terminal with the skeleton (A) (in the formula, R¹ represents a monovalent aromatic group).

3. The polyester resin according to claim 1 or 2, wherein a molar ratio of oxycarbonyl groups derived from the skeleton (A) to oxycarbonyl groups derived from the skeleton (B) ((A):(B)) is in a range of 30:70 to 95:5.

4. The polyester resin according to any one of claims 1 to 3, wherein:
an equivalent weight of total oxycarbonyl groups is 170 g/eq. or more; and
an equivalent weight of oxycarbonyl groups derived from the skeleton (A) is 220 g/eq. or more.

5. The polyester resin according to any one of claims 1 to 4, wherein a divalent aliphatic group represented by R² has 2 to 5 carbon atoms.

6. The polyester resin according to any one of claims 1 to 5, wherein
the polyester resin is a condensation reaction product of:
(x1) a hydroxy compound including at least a hydroxy compound having both an aromatic hydroxy group and an aliphatic hydroxy group;
(x2) a divalent aromatic carboxylic acid compound or a divalent aromatic carboxylic acid halide compound; and
(x3) a monovalent hydroxy compound having an aromatic hydroxy group.

7. The polyester resin according to claim 6, wherein the hydroxy compound (x1) is a reaction product of:
a hydroxy compound having two or more aromatic hydroxy groups; and
an aliphatic carbonate or an aliphatic oxide.

8. The polyester resin according to claim 6 or 7, wherein the hydroxy compound (x1) includes 10 mol% or more of a hydroxy compound having both an aromatic hydroxy group and an aliphatic hydroxy group.

9. The polyester resin according to any one of claims 1 to 8, containing a structural unit i represented by the following formula (i): 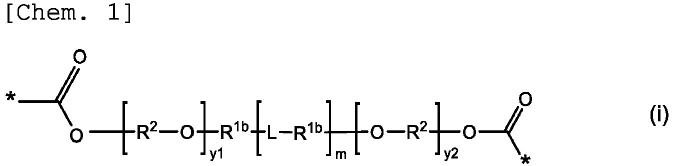 (in the formula:
R^{1b}s each independently represent a divalent aromatic group;
R²s each independently represent a divalent aliphatic group;
Ls each independently represent a single bond or a divalent linking group;
m is an integer of 0 to 5;
y1 and y2 are each independently 0 or 1; and
* indicates a bond, the bond being bonded to R³, where R³ indicates a divalent aromatic group).

10. The polyester resin according to claim 9, wherein, when an average number of the structural units i contained in the polyester resin per molecule is defined as N, N satisfies 0 < N ≤ 8.

11. The polyester resin according to claim 9 or 10, wherein, when an average number of the structural units i contained in the polyester resin per molecule is defined as N, an average number of a sum of a structural unit i-a represented by the following formula (i-a) and a structural unit i-b represented by the following formula (i-b) contained in the polyester resin per molecule is 0.1N or more: 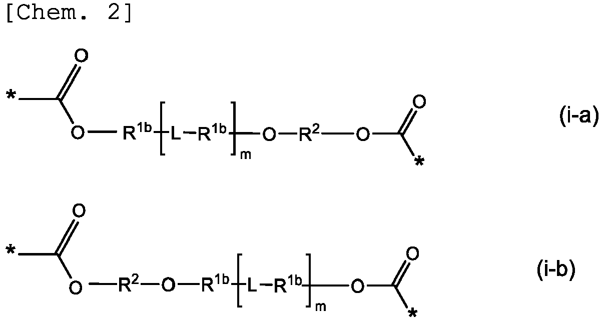 (in the formulas,
R^{1b}, R², L, m, and * are the same as above).

12. The polyester resin according to any one of claims 1 to 11, represented by the following formula (1): 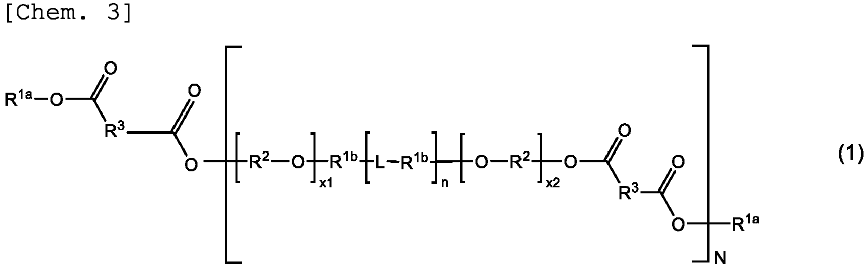 (in the formula:
R^{1a}s each independently represent a monovalent aromatic group;
R^{1b}s each independently represent a divalent aromatic group;
R²s each independently represent a divalent aliphatic group;
R³s each independently represent a divalent aromatic group;
Ls each independently represents a single bond or a divalent linking group;
x1 and x2 represent numbers that satisfy 0 ≤ x1 ≤ 1, 0 ≤ x2 ≤ 1, and 0 < x1 + x2 < 2;
n represents a number in a range of 0 to 5; and
N represents a repeating number satisfying 0 < N ≤ 8.) .

13. The polyester resin according to claim 12, wherein x1 and x2 satisfy 0.1 ≤ x1 + x2 ≤ 1.5.

14. The polyester resin according to claim 12 or 13, wherein x1 and x2 satisfy one of the following conditions (a) to (c) :
(a) x1 = 0 and 0 < x2 ≤ 1,
(b) x2 = 0 and 0 < x1 ≤ 1, and
(c) when the number of molecules of the polyester resin is defined as Z, only one of x1 and x2 is 0 in at least one combination of x1 and x2 out of Z × N combinations of x1 and x2.

15. The polyester resin according to any one of claims 12 to 14, wherein R^{1a} is a phenyl group optionally having a substituent or a naphthyl group optionally having a substituent.

16. The polyester resin according to any one of claims 9 to 15, wherein a divalent aliphatic group represented by R² has 2 to 5 carbon atoms.

17. The polyester resin according to any one of claims 9 to 16, wherein R^{1b} is a phenylene group optionally having a substituent or a naphthylene group optionally having a substituent.

18. The polyester resin according to any one of claims 9 to 17, wherein L is a divalent aliphatic group optionally having a substituent or a divalent aromatic group optionally having a substituent.

19. The polyester resin according to any one of claims 1 to 18, having a number-average molecular weight of 5,000 or less.

20. A resin cross-linking agent comprising the polyester resin according to any one of claims 1 to 19.

21. A resin composition comprising the polyester resin (X) according to any one of claims 1 to 19, and a cross-linkable resin (Y).

22. The resin composition according to claim 21, wherein the cross-linkable resin (Y) is one or more types selected from the group consisting of a thermosetting resin and a radically polymerizable resin.

23. The resin composition according to claim 21 or 22, wherein a mass ration ((X)/(Y)) of the polyester resin (X) to the cross-linkable resin (Y) is 1.2 to 2.0.

24. The resin composition according to any one of claims 21 to 23, further comprising an inorganic filler.

25. The resin composition according to any one of claims 21 to 24, further comprising an organic solvent.

26. The resin composition according to any one of claims 21 to 25, for an insulation layer of a printed wiring board.

27. The resin composition according to any one of claims 21 to 25, for sealing semiconductor.

28. A resin sheet comprising: a support; and a layer of the resin composition according to any one of claims 21 to 27, disposed on the support.

29. A prepreg formed by impregnating a sheet-like fiber substrate with the resin composition according to any one of claims 21 to 27.

30. A cured product of the resin composition according to any one of claims 21 to 27.

31. A printed wiring board comprising an insulation layer formed of a cured product of the resin composition according to any one of claims 21 to 26.

32. A semiconductor chip package comprising a sealing layer formed of a cured product of the resin composition according to any one of claims 21 to 25 and 27.

33. The semiconductor chip package according to claim 32, wherein the semiconductor chip package is a fan-out type package.

34. A semiconductor device comprising the printed wiring board according to claim 31 or the semiconductor chip package according to claim 32 or 33.
